# EUROPEAN PATENT APPLICATION

(11) **EP 4 543 173 A1**
(43) Date of publication of application: **23.04.2025**
(21) Application number: 24206637.1
(22) Date of filing: 15.10.2024
(51) Int. Cl.: H10K 59/10, H10K 59/124, H10K 59/131, H10K 59/80, H10K 102/00

(54) **DISPLAY DEVICE AND HEAD MOUNTED DISPLAY INCLUDING THE SAME**

(30) Priority: 16.10.2023 KR 20230137752
(71) Applicant: Samsung Display Co., Ltd., Gyeonggi-do 17113 (KR)
(72) Inventor: YOU, Chun Gi, Yongin-si (KR); KIM, Sang Yeol, Yongin-si (KR); PARK, Jung Tae, Yongin-si (KR)
(74) Representative: Marks & Clerk LLP

(57) **Abstract**

Provided are a display device, and a head mounted display comprising the display device, the display device including a semiconductor substrate including transistors, conductive layers above the semiconductor substrate, a reflective electrode layer above the conductive layers, an optical auxiliary layer above the reflective electrode layer, light-emitting elements above the optical auxiliary layer, and including a first electrode, a light-emitting stack, and a second electrode, a pixel-defining film above the first electrode to partition light-emitting areas of the light-emitting elements, a first pad conductive layer above the conductive layers, and a second pad conductive layer above the first pad conductive layer, a thickness of the first pad conductive layer and a thickness of the second pad conductive layer being greater than a thickness of the reflective electrode layer.

## Description

### BACKGROUND

### 1. Field

One or more embodiments of the present disclosure relate to a display device and a head mounted display including the same.

### 2. Description of the Related Art

A head mounted display (HMD) is an image display device that is worn on a user's head in the form of glasses or helmets to form a focus at a close distance in front of the user's eyes. The head mounted display may implement virtual reality (VR) or augmented reality (AR).

The head mounted display magnifies an image displayed on a small display device by using a plurality of lenses, and displays the magnified image. Therefore, the display device applied to the head mounted display may suitably provide high-resolution images, for example, images with a resolution of 3000 PPI (Pixels Per Inch) or higher. To this end, an organic light-emitting diode on silicon (OLEDoS), which is a high-resolution small organic light-emitting display device, is used as the display device applied to the head mounted display. The OLEDoS is an image display device in which an organic light-emitting diode (OLED) is located on a semiconductor wafer substrate including complementary metal oxide semiconductor (CMOS).

### SUMMARY

Aspects of embodiments of the present disclosure provide a display device capable of providing high-resolution images.

Aspects of embodiments of the present disclosure also provide a head mounted display device capable of providing high-resolution images.

However, embodiments of the present disclosure are not limited to those set forth herein. The above and other embodiments of the present disclosure will become more apparent to one of ordinary skill in the art to which the present disclosure pertains by referencing the detailed description of the present disclosure given below.

According to one or more embodiments of the present disclosure, there is provided a display device including a semiconductor substrate including transistors, conductive layers above the semiconductor substrate, a reflective electrode layer above the conductive layers, an optical auxiliary layer above the reflective electrode layer, light-emitting elements above the optical auxiliary layer, and including a first electrode, a light-emitting stack, and a second electrode, a pixel-defining film above the first electrode to partition light-emitting areas of the light-emitting elements, a first pad conductive layer above the conductive layers, and a second pad conductive layer above the first pad conductive layer, a thickness of the first pad conductive layer and a thickness of the second pad conductive layer being greater than a thickness of the reflective electrode layer.

The first pad conductive layer and the second pad conductive layer may include a first sub-pad and a second sub-pad partitioned by the optical auxiliary layer.

An area of the first sub-pad may be larger than an area of the second sub-pad.

The first pad conductive layer and the second pad conductive layer may further include a third sub-pad partitioned by the optical auxiliary layer.

An area of the first sub-pad may be larger than an area of the second sub-pad, wherein an area of the first sub-pad is larger than an area of the third sub-pad.

The display device may further include a trench penetrating the pixel-defining film and a portion of the optical auxiliary layer.

The light-emitting stack may include a first stack layer for emitting light of a first color in the trench, and a second stack layer for emitting light of a second color in the trench and spaced apart from the first stack layer.

The light-emitting stack may further include a first charge generation layer between the first stack layer and the second stack layer, and separated at the trench.

The pixel-defining film may further include a first pixel-defining film covering at least a part of the first electrode, a second pixel-defining film above the first pixel-defining film and exposing a part of a top surface of the first pixel-defining film, and a third pixel-defining film above the second pixel-defining film and exposing a part of a top surface of the second pixel-defining film.

The trench may penetrate the first pixel-defining film, the second pixel-defining film, and the third pixel-defining film.

The reflective electrode layer may include a first reflective conductive layer, a second reflective conductive layer above the first reflective conductive layer, and a step layer between the first reflective conductive layer and the second reflective conductive layer.

The display device may further include a first power connection electrode above the conductive layers, a via penetrating the optical auxiliary layer covering the first power connection electrode to be connected to the first power connection electrode, and a second power connection electrode above the optical auxiliary layer, connected to the via, and connected to the second electrode.

The pixel-defining film may be above at least a portion of the second power connection electrode.

The reflective electrode layer may include a first reflective conductive layer, a second reflective conductive layer above the first reflective conductive layer, and a step layer between the first reflective conductive layer and the second reflective conductive layer, wherein the first power connection electrode includes a first sub-power connection electrode including a same material as the first reflective conductive layer, and a second sub-power connection electrode including a same material as the second reflective conductive layer.

The display device may further include a dam penetrating the pixel-defining film, and a portion of the optical auxiliary layer.

A depth of the dam may be substantially equal to a depth of the trench.

The display device may further include an encapsulation layer above the light-emitting elements and the pixel-defining film, and including a first encapsulation inorganic layer in the dam, and an encapsulation organic layer.

The encapsulation organic layer may be above the first encapsulation inorganic layer in the dam.

The first pad conductive layer and the second pad conductive layer may further include a first sub-pad conductive layer, and a second sub-pad conductive layer having a thickness that is less than a thickness of the first sub-pad conductive layer, wherein the display device further including a permeation reduction electrode above the conductive layers, and wherein the permeation reduction electrode further includes a first sub-permeation reduction electrode including a same material as the first pad conductive layer, and a second sub-permeation reduction electrode including a same material as the second pad conductive layer.

According to one or more embodiments of the present disclosure, there is provided a display device including a display area including pixels, a power connection area outside the display area, a dam area outside the power connection area, a first distribution circuit at a first side of the display area in a first direction, a data driver outside the first distribution circuit in the first direction, a pad area outside the data driver in the first direction, an electrostatic protection area outside the pad area in the first direction, a permeation reduction area outside the electrostatic protection area in the first direction, and a crack reduction area outside the permeation reduction area in the first direction.

The power connection area may surround the display area in plan view, wherein the dam area surrounds the power connection area in plan view, wherein the pad area is outside the dam area, wherein the electrostatic protection area surrounds the dam area in plan view, wherein the permeation reduction area surrounds the electrostatic protection area in plan view, and wherein the crack reduction area surrounds the permeation reduction area in plan view.

According to one or more embodiments of the present disclosure, there is provided a head mounted display device including a display device housing configured to accommodate at least one display device, and an optical member configured to magnify a display image of the at least one display device, or to change an optical path, wherein the at least one display device includes a semiconductor substrate including transistors, conductive layers above the semiconductor substrate, a reflective electrode layer above the conductive layers, an interlayer insulating layer above the reflective electrode layer, light-emitting elements above the interlayer insulating layer, and including a first electrode, a light-emitting stack, and a second electrode, a pixel-defining film above the first electrode to partition light-emitting areas where the light-emitting elements are respectively located, a first pad conductive layer above the conductive layers, and a second pad conductive layer above the first pad conductive layer, a thickness of the first pad conductive layer and a thickness of the second pad conductive layer being greater than a thickness of the reflective electrode layer.

According to the aforementioned and other embodiments of the present disclosure, the size of a plurality of pixels may be greatly reduced by forming a light-emitting element backplane and a light-emitting element layer on a semiconductor substrate on which a plurality of transistors are formed, so that the display device that displays high-resolution images may be provided.

Further, according to the aforementioned and other embodiments of the present disclosure, a first pad conductive layer of a first sub-pad and a second pad conductive layer of a second sub-pad are separated or distinguished from each other, so that although the second pad conductive layer of the second sub-pad may be damaged or broken by a jig or a probe pin in an inspection process, the first pad conductive layer of the first sub-pad may not be damaged or broken.

At least some of the above and other features of the invention are set out in the claims.

### BRIEF DESCRIPTION OF DRAWINGS

The above and other embodiments of the present disclosure will become more apparent by describing embodiments thereof with reference to the attached drawings, in which:
FIG. 1 is an exploded perspective view showing a display device according to one or more embodiments;
FIG. 2 is a block diagram illustrating a display device according to one or more embodiments;
FIG. 3 is an equivalent circuit diagram of a first sub-pixel according to one or more embodiments;
FIG. 4 is a layout diagram illustrating a display panel according to one or more embodiments;
FIG. 5 is a layout diagram illustrating a first electrode, a light-emitting area, and a pixel-defining film of each sub-pixel of the display area of FIG. 4;
FIG. 6 is a layout diagram illustrating a first electrode, a light-emitting area, and a pixel-defining film of each of the sub-pixels according to still one or more other embodiments;
FIG. 7 is a cross-sectional view illustrating the display device taken along the line A-A' of FIG. 5;
FIG. 8 is a layout diagram illustrating the first pad of the first pad portion of FIG. 4;
FIG. 9 is a cross-sectional view illustrating a display panel taken along the line B-B' of FIG. 8;
FIG. 10 is a layout diagram illustrating yet another example of the first pad of the first pad portion of FIG. 4;
FIG. 11 is a cross-sectional view illustrating a display panel taken along the line C-C' of FIG. 10;
FIG. 12 is a layout diagram illustrating yet another example of the first pad of the first pad portion of FIG. 4;
FIG. 13 is a cross-sectional view illustrating a display panel taken along the line D-D' of FIG. 12;
FIG. 14 is a layout diagram showing in detail an area X of FIG. 4;
FIG. 15 is a cross-sectional view illustrating a display panel taken along the line E-E' of FIG. 14;
FIG. 16 is a cross-sectional view illustrating a display panel taken along the line F-F' of FIG. 14;
FIG. 17 is a layout diagram showing in detail an area Y of FIG. 4;
FIG. 18 is a cross-sectional view illustrating a display panel taken along the line G-G' of FIG. 17;
FIG. 19 is a layout diagram showing in detail an area Z of FIG. 4;
FIG. 20 is a cross-sectional view illustrating a display panel taken along the lines H-H' and I-I' of FIG. 19;
FIG. 21 is a perspective view illustrating a head mounted display device according to one or more embodiments;
FIG. 22 is an exploded perspective view illustrating the head mounted display device of FIG. 21; and
FIG. 23 is a perspective view illustrating a head mounted display device according to one or more embodiments.

### DETAILED DESCRIPTION

Aspects of embodiments of the present disclosure and methods of accomplishing the same may be understood more readily by reference to the detailed description of embodiments and the accompanying drawings. Hereinafter, embodiments will be described in more detail with reference to the accompanying drawings. The described embodiments, however, may be embodied in various different forms, and should not be construed as being limited to only the illustrated embodiments herein. Rather, these embodiments are provided as examples so that the present disclosure will be thorough and complete, and will fully convey the aspects of the present disclosure to those skilled in the art. Accordingly, processes, elements, and techniques that are not necessary to those having ordinary skill in the art for a complete understanding of the aspects of the present disclosure might not be described.

Unless otherwise noted, like reference numerals, characters, or combinations thereof denote like elements throughout the attached drawings and the written description, and thus, descriptions thereof will not be repeated. Further, parts not related to the description of one or more embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the present disclosure. Thus, embodiments disclosed herein should not be construed as limited to the particular illustrated shapes of regions, but are to include deviations in shapes that result from, for instance, manufacturing.

For example, an implanted region illustrated as a rectangle may have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the drawings are schematic in nature and their shapes are not intended to illustrate the actual shape of a region of a device and are not intended to be limiting. Additionally, as those skilled in the art would realize, the described embodiments may be modified in various different ways, all without departing from the scope of the present disclosure.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form to avoid unnecessarily obscuring various embodiments.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, in this specification, the phrase "on a plane," or "in a plan view," means viewing a target portion from the top, and the phrase "on a cross-section" means viewing a cross-section formed by vertically cutting a target portion from the side.

It will be understood that when an element, layer, region, or component is referred to as being "formed on," "on," "connected to," or "coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled" refers to one component directly connecting or coupling another component without an intermediate component. Meanwhile, other expressions describing relationships between components, such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of the present disclosure, expressions, such as "at least one of," "one of," and "selected from," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, XZ, YZ, and ZZ, or any variation thereof. Similarly, the expression, such as "at least one of A and/or B" may include A, B, or A and B. As used herein, the term "and/or" includes any and all combinations of one or more of the associated listed items. For example, the expression, such as "A and/or B" may include A, B, or A and B. Further, the use of "may" when describing embodiments of the present disclosure refers to "one or more embodiments of the present disclosure".

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

When one or more embodiments may be implemented differently, a specific process order may be performed differently from the described order. For example, two consecutively described processes may be performed substantially at the same time or performed in an order opposite to the described order.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, for example, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

The electronic or electric devices and/or any other relevant devices or components according to one or more embodiments of the present disclosure described herein may be implemented utilizing any suitable hardware, firmware (e.g., an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning for example consistent with their meaning in the context of the relevant art and/or the present disclosure, and should not be interpreted in an idealized or overly formal sense, unless expressly so defined herein.

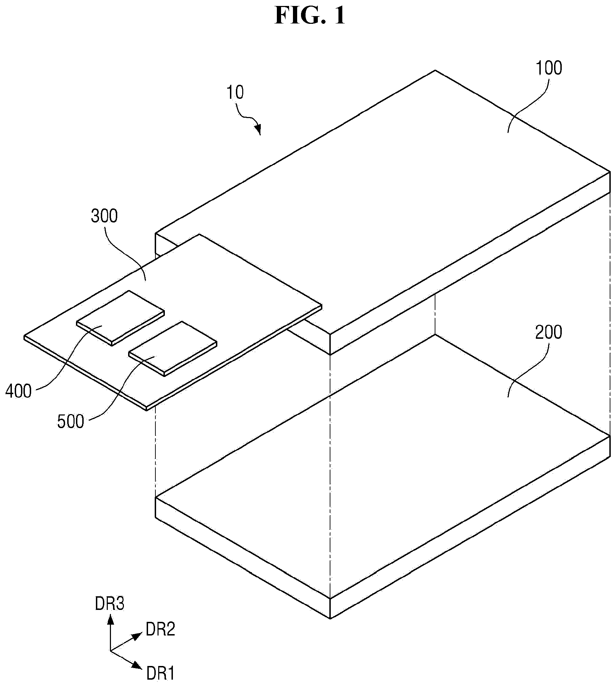

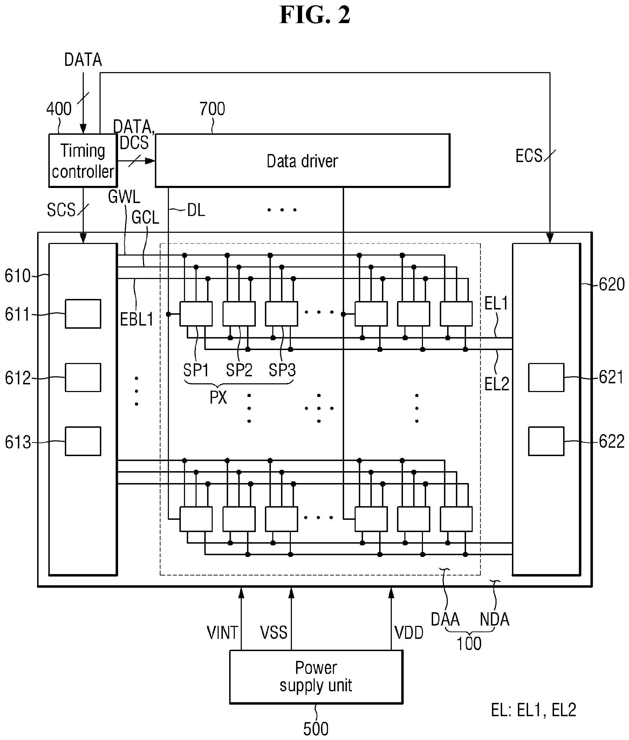

FIG. 1 is an exploded perspective view showing a display device according to one or more embodiments. FIG. 2 is a block diagram illustrating a display device according to one or more embodiments.

Referring to FIGS. 1 and 2, a display device 10 according to one or more embodiments is a device displaying a moving image or a still image. The display device 10 according to one or more embodiments may be applied to portable electronic devices, such as a mobile phone, a smartphone, a tablet personal computer, a mobile communication terminal, an electronic organizer, an electronic book, a portable multimedia player (PMP), a navigation system, an ultra-mobile PC (UMPC) or the like. For example, the display device 10 according to one or more embodiments may be applied as a display of a television, a laptop, a monitor, a billboard, or an Internet-of-Things (IoT) terminal. Alternatively, the display device 10 according to one or more embodiments may be applied to a smart watch, a watch phone, a head mounted display (HMD) for implementing virtual reality and augmented reality, and the like.

The display device 10 according to one or more embodiments includes a display panel 100, a heat dissipation layer 200, a circuit board 300, a timing control circuit 400, and a power supply circuit 500.

The display panel 100 may have a planar shape similar to a quadrilateral shape. For example, the display panel 100 may have a planar shape similar to a quadrilateral shape, having a short side of the first direction DR1, and a long side of the second direction DR2 crossing the first direction DR1. In the display panel 100, a corner where a short side in the first direction DR1 and a long side in the second direction DR2 meet may be right-angled or rounded with a curvature (e.g., predetermined curvature). The planar shape of the display panel 100 is not limited to a quadrilateral shape, and may be a shape similar to another polygonal shape, a circular shape, or an elliptical shape. The planar shape of the display device 10 may conform to the planar shape of the display panel 100, but the present disclosure is not limited thereto.

The display panel 100 includes a display area DAA for displaying an image, and a non-display area NDA not displaying an image, as shown in FIG. 2.

The display area DAA includes a plurality of pixels PX, a plurality of scan lines, a plurality of emission control lines EL, and a plurality of data lines DL.

The plurality of pixels PX may be arranged in a matrix form in the first direction DR1 and the second direction DR2. The plurality of scan lines and the plurality of emission control lines EL may extend in the first direction DR1, while being arranged in the second direction DR2. The plurality of data lines DL may extend in the second direction DR2, while being arranged in the first direction DR1.

The plurality of scan lines include a plurality of write scan lines GWL, a plurality of control scan lines GCL, and a plurality of bias scan lines EBL. The plurality of emission control lines EL include a plurality of first emission control lines EL1 and a plurality of second emission control lines EL2.

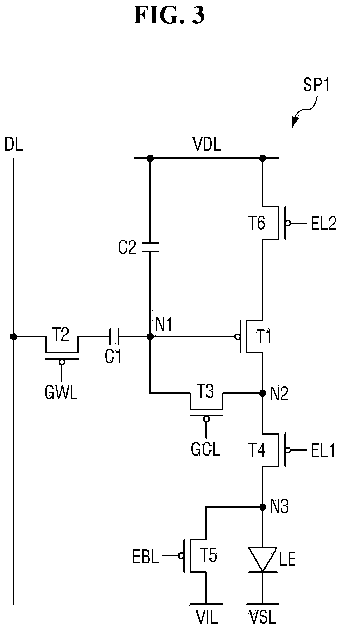

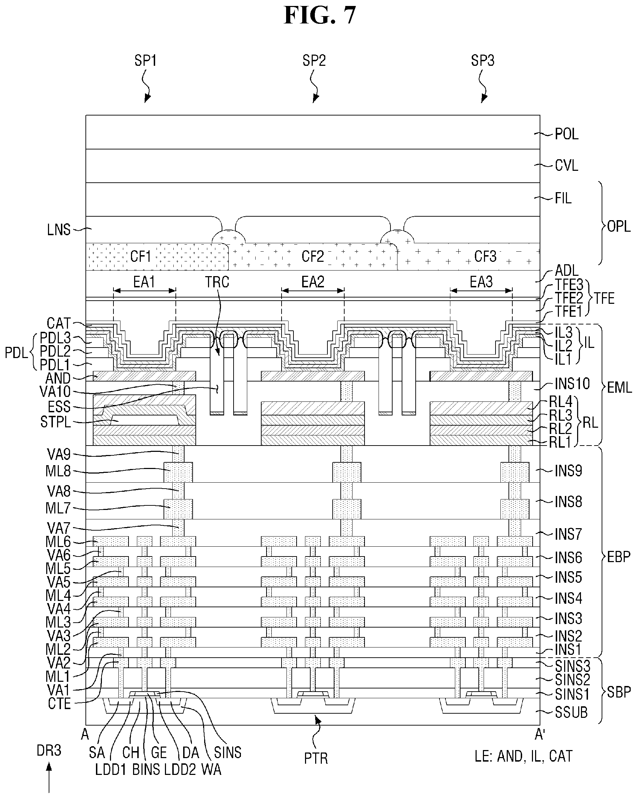

The plurality of pixels PX include a plurality of sub-pixels SP1, SP2, and SP3. Each of the plurality of sub-pixels SP1, SP2, and SP3 may include a plurality of pixel transistors as shown in FIG. 3, and the plurality of pixel transistors may be formed by a semiconductor process and located on a semiconductor substrate SSUB (see FIG. 7). For example, the plurality of pixel transistors may be formed of complementary metal oxide semiconductor (CMOS).

Each of the plurality of sub-pixels SP1, SP2, and SP3 may be connected to any one write scan line GWL among the plurality of write scan lines GWL, any one control scan line GCL among the plurality of control scan lines GCL, any one bias scan line EBL among the plurality of bias scan lines EBL, any one first emission control line EL1 among the plurality of first emission control lines EL1, any one second emission control line EL2 among the plurality of second emission control lines EL2, and any one data line DL among the plurality of data lines DL. Each of the plurality of sub-pixels SP1, SP2, and SP3 may receive a data voltage of the data line DL in response to a write scan signal of the write scan line GWL, and emit light from the light-emitting element according to the data voltage.

The non-display area NDA includes a scan driver 610, an emission driver 620, and a data driver 700.

The scan driver 610 includes a plurality of scan transistors, and the emission driver 620 includes a plurality of light-emitting transistors. The plurality of scan transistors and the plurality of light-emitting transistors may be formed on the semiconductor substrate SSUB (see FIG. 7) through a semiconductor process. For example, the plurality of scan transistors and the plurality of light-emitting transistors may be formed of CMOS. Although it is illustrated in FIG. 2 that the scan driver 610 is located on the left side of the display area DAA and the emission driver 620 is located on the right side of the display area DAA, the present disclosure is not limited thereto. For example, both the scan driver 610 and the emission driver 620 may be located on the left side or the right side of the display area DAA.

The scan driver 610 may include a write scan signal output 611, a control scan signal output 612, and a bias scan signal output 613. Each of the write scan signal output 611, the control scan signal output 612, and the bias scan signal output 613 may receive a scan timing control signal SCS from the timing control circuit 400. The write scan signal output 611 may generate write scan signals according to the scan timing control signal SCS of the timing control circuit 400 and output the write scan signals sequentially to the write scan lines GWL. The control scan signal output 612 may generate control scan signals in response to the scan timing control signal SCS and sequentially output the control scan signals to the control scan lines GCL. The bias scan signal output 613 may generate bias scan signals according to the scan timing control signal SCS and output the bias scan signals sequentially to bias scan lines EBL.

The emission driver 620 includes a first emission control driver 621 and a second emission control driver 622. Each of the first emission control driver 621 and the second emission control driver 622 may receive an emission timing control signal ECS from the timing control circuit 400. The first emission control driver 621 may generate first emission control signals according to the emission timing control signal ECS and sequentially output the first emission control signals to the first emission control lines EL1. The second emission control driver 622 may generate second emission control signals according to the emission timing control signal ECS and sequentially output the second emission control signals to the second emission control lines EL2.

The data driver 700 may include a plurality of data transistors, and the plurality of data transistors may be formed on the semiconductor substrate SSUB (see FIG. 7) through a semiconductor process. For example, the plurality of data transistors of the data driver 700 may be formed of CMOS.

The data driver 700 may receive the digital video data DATA and the data timing control signal DCS from the timing control circuit 400. The data driver 700 converts the digital video data DATA into analog data voltages according to the data timing control signal DCS, and outputs the analog data voltages to the data lines DL. In this case, the sub-pixels SP1, SP2, and SP3 are selected by the write scan signal of the scan driver 610, and data voltages may be supplied to the selected sub-pixels SP1, SP2, and SP3.

The heat dissipation layer 200 may overlap the display panel 100 in a third direction DR3, which is the thickness direction of the display panel 100. The heat dissipation layer 200 may be located on one surface of the display panel 100, for example, on the rear surface thereof. The heat dissipation layer 200 serves to dissipate heat generated from the display panel 100. The heat dissipation layer 200 may include a conductive layer, such as graphite, silver (Ag), copper (Cu), or aluminum (Al) having high thermal conductivity.

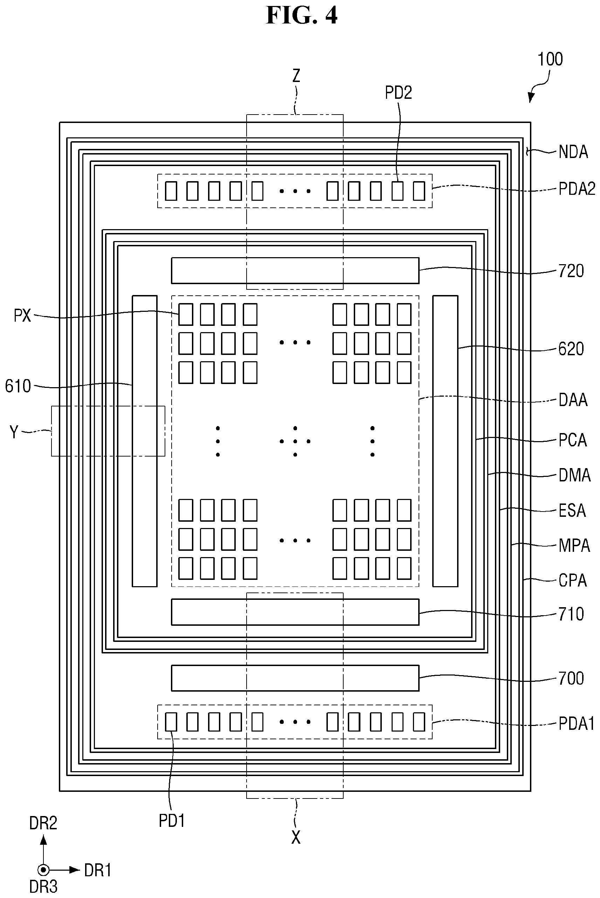

The circuit board 300 may be electrically connected to a plurality of first pads PD1 (see FIG. 4) of a first pad portion PDA1 (see FIG. 4) of the display panel 100 by using a conductive adhesive, such as an anisotropic conductive film. The circuit board 300 may be a flexible printed circuit board with a flexible material, or a flexible film. Although the circuit board 300 is illustrated in FIG. 1 as being unfolded, the circuit board 300 may be bent. In this case, one end of the circuit board 300 may be located on the rear surface of the display panel 100 and/or the rear surface of the heat dissipation layer 200. One end of the circuit board 300 may be an opposite end of the other end of the circuit board 300 connected to the plurality of first pads PD1 (see FIG. 4) of the first pad portion PDA1 (see FIG. 4) of the display panel 100 by using a conductive adhesive.

The timing control circuit 400 may receive digital video data and timing signals inputted from the outside. The timing control circuit 400 may generate the scan timing control signal SCS, the emission timing control signal ECS, and a data timing control signal DCS for controlling the display panel 100 in response to the timing signals. The timing control circuit 400 may output the scan timing control signal SCS to the scan driver 610, and output the emission timing control signal ECS to the emission driver 620. The timing control circuit 400 may output the digital video data and the data timing control signal DCS to the data driver 700.

The power supply circuit 500 may generate a plurality of panel driving voltages according to a power voltage from the outside. For example, the power supply circuit 500 may generate a first driving voltage VSS, a second driving voltage VDD, and a third driving voltage VINT and supply them to the display panel 100. The first driving voltage VSS, the second driving voltage VDD, and the third driving voltage VINT will be described later in conjunction with FIG. 3.

Each of the timing control circuit 400 and the power supply circuit 500 may be formed as an integrated circuit (IC) and attached to one surface of the circuit board 300. In this case, the scan timing control signal SCS, the emission timing control signal ECS, the digital video data DATA, and the data timing control signal DCS of the timing control circuit 400 may be supplied to the display panel 100 through the circuit board 300. Further, the first driving voltage VSS, the second driving voltage VDD, and the third driving voltage VINT of the power supply circuit 500 may be supplied to the display panel 100 through the circuit board 300.

Alternatively, each of the timing control circuit 400 and the power supply circuit 500 may be located in the non-display area NDA of the display panel 100, similarly to the scan driver 610, the emission driver 620, and the data driver 700. In this case, the timing control circuit 400 may include a plurality of timing transistors, and each of the power supply circuits 500 may include a plurality of power transistors. The plurality of timing transistors and the plurality of power transistors may be formed on the semiconductor substrate SSUB (see FIG. 7) through a semiconductor process. For example, the plurality of timing transistors and the plurality of power transistors may be formed of CMOS. Each of the timing control circuit 400 and the power supply circuit 500 may be located between the data driver 700 and the first pad portion PDA1 (see FIG. 4).

FIG. 3 is an equivalent circuit diagram of a first sub-pixel according to one or more embodiments.

Referring to FIG. 3, the first sub-pixel SP1 may be connected to the write scan line GWL, the control scan line GCL, the bias scan line EBL, the first emission control line EL1, the second emission control line EL2, and the data line DL. Further, the first sub-pixel SP1 may be connected to a first driving voltage line VSL to which the first driving voltage VSS corresponding to a low potential voltage is applied, a second driving voltage line VDL to which the second driving voltage VDD corresponding to a high potential voltage is applied, and a third driving voltage line VIL to which the third driving voltage VINT corresponding to an initialization voltage is applied. That is, the first driving voltage line VSL may be a low potential voltage line, the second driving voltage line VDL may be a high potential voltage line, and the third driving voltage line VIL may be an initialization voltage line. In this case, the first driving voltage VSS may be lower than the third driving voltage VINT. The second driving voltage VDD may be higher than the third driving voltage VINT.

The first sub-pixel SP1 includes a plurality of transistors T1, T2, T3, T4, T5, and T6, a light-emitting element LE, a first capacitor C1, and a second capacitor C2.

The light-emitting element LE emits light in response to a driving current flowing through the channel of the first transistor T1. The emission amount of the light-emitting element LE may be proportional to the driving current. The light-emitting element LE may be located between the fourth transistor T4 and the first driving voltage line VSL. The first electrode of the light-emitting element LE may be connected to the drain electrode of the fourth transistor T4, and the second electrode thereof may be connected to the first driving voltage line VSL. The first electrode of the light-emitting element LE may be an anode electrode, and the second electrode of the light-emitting element LE may be a cathode electrode. The light-emitting element LE may be an organic light-emitting diode including a first electrode, a second electrode, and an organic light-emitting layer located between the first electrode and the second electrode, but the present disclosure is not limited thereto. For example, the light-emitting element LE may be an inorganic light-emitting element including a first electrode, a second electrode, and an inorganic semiconductor located between the first electrode and the second electrode, in which case the light-emitting element LE may be a micro light-emitting diode.

The first transistor T1 may be a driving transistor that controls a source-drain current (hereinafter referred to as a "driving current") flowing between the source electrode and the drain electrode thereof according to a voltage applied to the gate electrode thereof. The first transistor T1 includes a gate electrode connected to a first node N1, a source electrode connected to the drain electrode of the sixth transistor T6, and a drain electrode connected to a second node N2.

The second transistor T2 may be located between one electrode of the first capacitor C1 and the data line DL. The second transistor T2 is turned on by the write scan signal of the write scan line GWL to connect the one electrode of the first capacitor C1 to the data line DL. Accordingly, the data voltage of the data line DL may be applied to the one electrode of the first capacitor C1. The second transistor T2 includes a gate electrode connected to the write scan line GWL, a source electrode connected to the data line DL, and a drain electrode connected to the one electrode of the first capacitor C1.

The third transistor T3 may be located between the first node N1 and the second node N2. The third transistor T3 is turned on by the write control signal of the write control line GCL to connect the first node N1 to the second node N2. For this reason, because the gate electrode and the source electrode of the first transistor T1 are connected, the first transistor T1 may operate like a diode. The third transistor T3 includes a gate electrode connected to the write control line GCL, a source electrode connected to the second node N2, and a drain electrode connected to the first node N1.

The fourth transistor T4 may be connected between the second node N2 and a third node N3. The fourth transistor T4 is turned on by the first emission control signal of the first emission control line EL1 to connect the second node N2 to the third node N3. Accordingly, the driving current of the first transistor T1 may be supplied to the light-emitting element LE. The fourth transistor T4 includes a gate electrode connected to the first emission control line EL1, a source electrode connected to the second node N2, and a drain electrode connected to the third node N3.

The fifth transistor T5 may be located between the third node N3 and the third driving voltage line VIL. The fifth transistor T5 is turned on by the bias scan signal of the bias scan line EBL to connect the third node N3 to the third driving voltage line VIL. Accordingly, the third driving voltage VINT of the third driving voltage line VIL may be applied to the first electrode of the light-emitting element LE. The fifth transistor T5 includes a gate electrode connected to the bias scan line EBL, a source electrode connected to the third node N3, and a drain electrode connected to the third driving voltage line VIL.

The sixth transistor T6 may be located between the source electrode of the first transistor T1 and the second driving voltage line VDL. The sixth transistor T6 is turned on by the second emission control signal of the second emission control line EL2 to connect the source electrode of the first transistor T1 to the second driving voltage line VDL. Accordingly, the second driving voltage VDD of the second driving voltage line VDL may be applied to the source electrode of the first transistor T1. The sixth transistor T6 includes a gate electrode connected to the second emission control line EL2, a source electrode connected to the second driving voltage line VDL, and a drain electrode connected to the source electrode of the first transistor T1.

The first capacitor C1 is formed between the first node N1 and the drain electrode of the second transistor T2. The first capacitor C1 includes one electrode connected to the drain electrode of the second transistor T2 and the other electrode connected to the first node N1.

The second capacitor C2 is formed between the gate electrode of the first transistor T1 and the second driving voltage line VDL. The second capacitor C2 includes one electrode connected to the gate electrode of the first transistor T1 and the other electrode connected to the second driving voltage line VDL.

The first node N1 is a junction between the gate electrode of the first transistor T1, the drain electrode of the third transistor T3, the other electrode of the first capacitor C1, and the one electrode of the second capacitor C2. The second node N2 is a junction between the drain electrode of the first transistor T1, the source electrode of the third transistor T3, and the source electrode of the fourth transistor T4. The third node N3 is a junction between the drain electrode of the fourth transistor T4, the source electrode of the fifth transistor T5, and the first electrode of the light-emitting element LE.

Each of the first to sixth transistors T1, T2, T3, T4, T5, and T6 may be a metal-oxide-semiconductor field effect transistor (MOSFET). For example, each of the first to sixth transistors T1, T2, T3, T4, T5, and T6 may be a P-type MOSFET, but the present disclosure is not limited thereto. Each of the first to sixth transistors T1, T2, T3, T4, T5, and T6 may be an N-type MOSFET. Alternatively, one or more of the first to sixth transistors T1, T2, T3, T4, T5, or T6 may be P-type MOSFETs, and one or more others of the remaining transistors may be an N-type MOSFET.

Although it is illustrated in FIG. 3 that the first sub-pixel SP1 includes six transistors T1, T2, T3, T4, T5, and T6 and two capacitors C1 and C2, it should be noted that the equivalent circuit diagram of the first sub-pixel SP1 is not limited to that shown in FIG. 3. For example, the number of transistors and the number of capacitors of the first sub-pixel SP1 are not limited to those shown in FIG. 3.

Further, the equivalent circuit diagram of the second sub-pixel SP2 and the equivalent circuit diagram of the third sub-pixel SP3 may be substantially the same as the equivalent circuit diagram of the first sub-pixel SP1 described in conjunction with FIG. 3. Therefore, the description of the equivalent circuit diagram of the second sub-pixel SP2 and the equivalent circuit diagram of the third sub-pixel SP3 is omitted in the present disclosure.

FIG. 4 is a layout diagram illustrating a display panel according to one or more embodiments.

Referring to FIG. 4, the display area DAA of the display panel 100 according to one or more embodiments includes the plurality of pixels PX arranged in a matrix form. The non-display area NDA of the display panel 100 according to one or more embodiments includes the scan driver 610, the emission driver 620, the data driver 700, a first distribution circuit 710, and a second distribution circuit 720, the first pad portion PDA1, a second pad portion PDA2, a power connection portion PCA, a dam portion DMA, an electrostatic protection area ESA, a permeation reduction area (e.g., permeation prevention portion) MPA, and a crack reduction area (e.g., crack prevention portion) CPA.

The scan driver 610 may be located on the first side of the display area DAA, and the emission driver 620 may be located on the second side of the display area DAA. For example, the scan driver 610 may be located on one side of the display area DAA in the first direction DR1, and the emission driver 620 may be located on the other side of the display area DAA in the first direction DR1. That is, the scan driver 610 may be located on the left side of the display area DAA, and the emission driver 620 may be located on the right side of the display area DAA. However, the present disclosure is not limited thereto, and both the scan driver 610 and the emission driver 620 may be located on the first side or the second side of the display area DAA.

The first pad portion PDA1 may include the plurality of first pads PD1 connected to pads or bumps of the circuit board 300 through a conductive adhesive. The first pad portion PDA1 may be located on the third side of the display area DAA. For example, the first pad portion PDA1 may be located on one side of the display area DAA in the second direction DR2.

The first pad portion PDA1 may be located outside the data driver 700 in the second direction DR2. That is, the first pad portion PDA1 may be closer to the edge of the display panel 100 than the data driver 700.

The second pad portion PDA2 may include a plurality of second pads PD2 corresponding to inspection pads that test whether the display panel 100 operates normally. The plurality of second pads PD2 may be connected to a jig or a probe pin during an inspection process, or may be connected to a circuit board for inspection. The circuit board for inspection may be a printed circuit board made of a rigid material or a flexible printed circuit board made of a flexible material.

The first distribution circuit 710 distributes data voltages applied through the first pad portion PDA1 to the plurality of data lines DL. For example, the first distribution circuit 710 may distribute the data voltages applied through one first pad PD1 of the first pad portion PDA1 to P data lines DL (P is a positive integer of 2 or more), and as a result, the number of the plurality of first pads PD1 may be reduced. The first distribution circuit 710 may be located on the third side of the display area DAA of the display panel 100. For example, the first distribution circuit 710 may be located on one side of the display area DAA in the second direction DR2. That is, the first distribution circuit 710 may be located on the lower side of the display area DAA.

The second distribution circuit 720 distributes signals applied through the second pad portion PDA2 to the scan driver 610, the emission driver 620, and the data lines DL. The second pad portion PDA2 and the second distribution circuit 720 may be configured to inspect the operation of each of the pixels PX in the display area DAA. The second distribution circuit 720 may be located on the fourth side of the display area DAA of the display panel 100. For example, the second distribution circuit 720 may be located on the other side of the display area DAA in the second direction DR2. That is, the second distribution circuit 720 may be located on the upper side of the display area DAA.

Each of the scan driver 610, the first distribution circuit 710, and the second distribution circuit 720 may include a plurality of data transistors, and the plurality of data transistors may be formed through a semiconductor process, and may be formed on the semiconductor substrate SSUB (see FIG. 7). For example, the plurality of data transistors of each of the scan driver 610, the first distribution circuit 710, and the second distribution circuit 720 may be formed of CMOS.

The power connection portion PCA refers to the area in which the second electrode of the light-emitting element LE (see FIG. 3), and the power connection electrode to which the first driving voltage VSS is applied, are connected, thereby enabling application of the first driving voltage VSS to the second electrode of the light-emitting element LE (see FIG. 3).

The power connection portion PCA may be located to surround the display area DA (as used herein, "surround" may mean "surround in plan view"). In addition, the power connection portion PCA may be located outside the scan driver 610, the emission driver 620, the first distribution circuit 710, and the second distribution circuit 720. For example, the power connection portion PCA may be closer to the edge of the display panel 100 than the scan driver 610, the emission driver 620, the first distribution circuit 710, and the second distribution circuit 720. The power connection portion PCA may be located to surround the scan driver 610, the emission driver 620, the first distribution circuit 710, and the second distribution circuit 720. However, the present disclosure is not limited thereto, and the power connection portion PCA may overlap at least one of the scan driver 610, the emission driver 620, the first distribution circuit 710, or the second distribution circuit 720 in the third direction DR3.

The dam portion DMA may be a structure to reduce or prevent overflow of an encapsulation organic layer TFE2 of an encapsulation layer TFE (see FIG. 7) for encapsulating the light-emitting elements LE (see FIG. 3) into the first pad portion PDA1 and the second pad portion PDA2.

The dam portion DMA may be located to surround the display area DA. In addition, the dam portion DMA may be located outside the scan driver 610, the emission driver 620, the first distribution circuit 710, and the second distribution circuit 720. For example, the dam portion DMA may be closer to the edge of the display panel 100 than the scan driver 610, the emission driver 620, the first distribution circuit 710, and the second distribution circuit 720. The dam portion DMA may be located to surround the scan driver 610, the emission driver 620, the first distribution circuit 710, and the second distribution circuit 720. However, the present disclosure is not limited thereto, and the dam portion DMA may overlap at least one of the scan driver 610, the emission driver 620, the first distribution circuit 710, or the second distribution circuit 720 in the third direction DR3.

In addition, the dam portion DMA may be located outside the power connection portion PCA. For example, the dam portion DMA may be closer to the edge of the display panel 100 than the power connection portion PCA. The dam portion DMA may be located to surround the power connection portion PCA.

The electrostatic protection area ESA may be a structure for protecting the pixels PX, the scan driver 610, the emission driver 620, the first distribution circuit 710, the second distribution circuit 720, the first pad portion PDA1, and the second pad portion PDA2 of the display panel 100 from static electricity applied from the outside. To this end, the first driving voltage VSS may be applied to the electrostatic protection area ESA. The electrostatic protection area ESA may be located to surround the display area DA.

In addition, the electrostatic protection area ESA may be located outside the scan driver 610, the emission driver 620, the first distribution circuit 710, and the second distribution circuit 720. For example, the electrostatic protection area ESA may be closer to the edge of the display panel 100 than the scan driver 610, the emission driver 620, the first distribution circuit 710, and the second distribution circuit 720. The electrostatic protection area ESA may be located to surround the scan driver 610, the emission driver 620, the first distribution circuit 710, and the second distribution circuit 720.

In addition, the electrostatic protection area ESA may be located outside the power connection portion PCA. For example, the electrostatic protection area ESA may be closer to the edge of the display panel 100 than the power connection portion PCA. The electrostatic protection area ESA may be located to surround the power connection portion PCA.

In addition, the electrostatic protection area ESA may be located outside the dam portion DMA. For example, the electrostatic protection area ESA may be closer to the edge of the display panel 100 than the dam portion DMA. The electrostatic protection area ESA may be located to surround the dam portion DMA.

In addition, the electrostatic protection area ESA may be located outside the first pad portion PDA1 and outside the second pad portion PDA2. For example, the electrostatic protection area ESA may be closer to the edge of the display panel 100 than the first pad portion PDA1 and the second pad portion PDA2. The electrostatic protection area ESA may be located to surround the first pad portion PDA1 and the second pad portion PDA2.

The permeation reduction area MPA may be a structure to protect transistors of the semiconductor substrate SSUB (see FIG. 7) from external moisture or oxygen. The permeation reduction area MPA may be located outside the electrostatic protection area ESA. For example, the permeation reduction area MPA may be closer to the edge of the display panel 100 than the electrostatic protection area ESA. The permeation reduction area MPA may be located to surround the electrostatic protection area ESA.

The crack reduction area CPA may be a structure to reduce or prevent the likelihood of cracks generated at the edges of the display panel 100 due to external impact from propagating to the center of the display panel 100. The crack reduction area CPA may be located outside the permeation reduction area MPA. For example, the crack reduction area CPA may be closer to the edge of the display panel 100 than the permeation reduction area MPA. The crack reduction area CPA may be located to surround the permeation reduction area MPA.

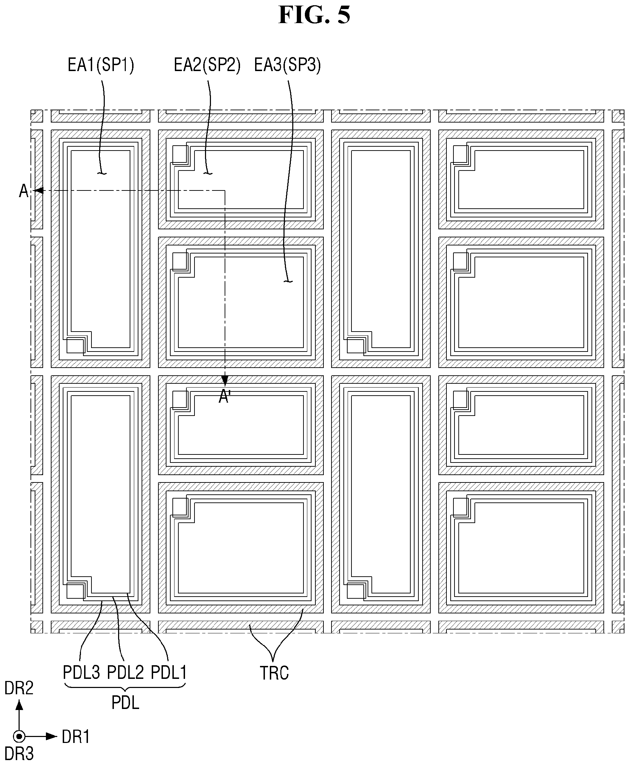

FIG. 5 is a layout diagram illustrating a first electrode, a light-emitting area, and a pixel-defining film of each sub-pixel of the display area of FIG. 4.

Referring to FIG. 5, each of the pixels PX includes the first light-emitting area EA1 that is a light-emitting area of the first sub-pixel SP1, the second light-emitting area EA2 that is a light-emitting area of the second sub-pixel SP2, and the third light-emitting area EA3 that is a light-emitting area of the third sub-pixel SP3.

Each of the first light-emitting area EA1, the second light-emitting area EA2, and the third light-emitting area EA3 may be an area defined by a pixel-defining film PDL. For example, each of the first light-emitting area EA1, the second light-emitting area EA2, and the third light-emitting area EA3 may be an area defined by a first pixel-defining film PDL1.

The length of the first light-emitting area EA1 in the first direction DR1 may be less than the length of the second light-emitting area EA2 in the first direction DR1, and may be less than the length of the third light-emitting area EA3 in the first direction DR1. Alternatively, the length of the first light-emitting area EA1 in the first direction DR1 may be substantially the same as the length of the second light-emitting area EA2 in the first direction DR1 and the length of the third light-emitting area EA3 in the first direction DR1.

In each of the plurality of pixels PX, the first light-emitting area EA1 and the second light-emitting area EA2 may be adjacent to each other in the first direction DR1. Further, the first light-emitting area EA1 and the third light-emitting area EA3 may be adjacent to each other in the first direction DR1. In addition, the second light-emitting area EA2 and the third light-emitting area EA3 may be adjacent to each other in the second direction DR2. The area of the first light-emitting area EA1, the area of the second light-emitting area EA2, and the area of the third light-emitting area EA3 may be different.

The first light-emitting area EA1 may emit light of a first color, the second light-emitting area EA2 may emit light of a second color, and the third light-emitting area EA3 may emit light of a third color. Here, the first color light may be light of a blue wavelength band, the second color light may be light of a green wavelength band, and the third color light may be light of a red wavelength band. For example, the blue wavelength band may be a wavelength band of light whose main peak wavelength is in the range of about 370 nm to about 460 nm, the green wavelength band may be a wavelength band of light whose main peak wavelength is in the range of about 480 nm to about 560 nm, and the red wavelength band may be a wavelength band of light whose main peak wavelength is in the range of about 600 nm to about 750 nm.

A first electrode AND of the light-emitting element LE may have a rectangular shape in plan view. The planar shape of the first electrode AND of the light-emitting element LE may be different in the first sub-pixel SP1, the second sub-pixel SP2, and the third sub-pixel SP3. For example, the first electrode AND of the first sub-pixel SP1 may have a rectangular shape, in plan view, having a short side in the first direction DR1 and a long side in the second direction DR2. The first electrode AND of each of the second sub-pixel SP2 and the third sub-pixel SP3 may have a rectangular shape, in plan view, having a long side in the first direction DR1 and a short side in the second direction DR2. The length of the first electrode AND of the second sub-pixel SP2 in the second direction DR2 may be shorter than the length of the first electrode AND of the third sub-pixel SP3 in the second direction DR2.

The first electrode AND of the light-emitting element LE may be connected to a reflective electrode layer RL (see FIG. 7) through a tenth via VA10. The tenth via VA10 may overlap the first pixel-defining film PDL1, a second pixel-defining film PDL2, and a third pixel-defining film PDL3 in the third direction DR3.

At least one trench TRC may be a structure for cutting off at least one charge generation layer of a light-emitting stack IL between the neighboring light-emitting areas EA1, EA2, and EA3. At least one trench TRC may be located between the first light-emitting area EA1 and the second light-emitting area EA2, between the first light-emitting area EA1 and the third light-emitting area EA3, and between the second light-emitting area EA2 and the third light-emitting area EA3. For example, at least one trench TRC may be located between the first electrode AND of the first sub-pixel SP1 and the first electrode AND of the second sub-pixel SP2, between the first electrode AND of the first sub-pixel SP1 and the first electrode AND of the third sub-pixel SP3, and between the first electrode AND of the second sub-pixel SP2 and the first electrode AND of the third sub-pixel SP3.

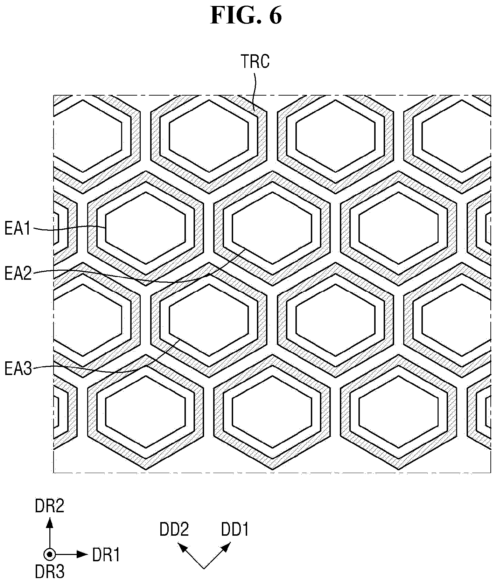

FIG. 6 is a layout diagram illustrating a first electrode, a light-emitting area, and a pixel-defining film of each of the sub-pixels according to still one or more other embodiments.

Because the one or more embodiments corresponding to FIG. 6 is substantially the same as the one or more embodiments corresponding to FIG. 5, except that the planar shapes of the first light-emitting area EA1, the second light-emitting area EA2, and the third light-emitting area EA3 are different from those of the one or more embodiments corresponding to FIG. 5, repeated description overlapping with the one or more embodiments corresponding to FIG. 5 will be omitted.

Referring to FIG. 6, the first light-emitting area EA1, the second light-emitting area EA2, and the third light-emitting area EA3 may be located in a hexagonal structure having a hexagonal shape in plan view. In this case, the first light-emitting area EA1 and the second light-emitting area EA2 may be adjacent to each other in the first direction DR1, but the second light-emitting area EA2 and the third light-emitting area EA3 may be adjacent to each other in a first diagonal direction DD1, and the first light-emitting area EA1 and the third light-emitting area EA3 may be adjacent to each other in a second diagonal direction DD2. The first diagonal direction DD1 may be a direction between the first direction DR1 and the second direction DR2, and may refer to a direction inclined by 45 degrees with respect to the first direction DR1 and the second direction DR2, and the second diagonal direction DD2 may be a direction perpendicular to the first diagonal direction DD1.

It is shown in FIGS. 5 and 6 that each of the plurality of pixels PX includes three light-emitting areas EA1, EA2, and EA3, but the present disclosure is not limited thereto. That is, each of the plurality of pixels PX may include four light-emitting areas.

In addition, the disposition of the light-emitting areas EA1, EA2, and EA3 of the plurality of pixels PX is not limited to that illustrated in FIGS. 5 and 6. For example, the light-emitting areas of the plurality of pixels PX may be located in a stripe structure in which the light-emitting areas are arranged in the first direction DR1, a PenTile^{®} structure in which the light-emitting areas are arranged in a diamond shape, or the like (PenTile^{®} and PENTILE^{™} being registered trademarks of Samsung Display Co., Ltd., Republic of Korea).

FIG. 7 is a cross-sectional view illustrating the display device taken along the line A-A' of FIG. 5.

Referring to FIG. 7, the display panel 100 includes a semiconductor backplane SBP, a light-emitting element backplane EBP, a display element layer EML, an encapsulation layer TFE, an optical layer OPL, the cover layer CVL, and a polarizing plate POL.

The semiconductor backplane SBP includes the semiconductor substrate SSUB including a plurality of pixel transistors PTR, a plurality of semiconductor insulating layers covering the plurality of pixel transistors PTR, and a plurality of contact terminals CTE electrically connected to the plurality of pixel transistors PTR, respectively. The plurality of pixel transistors PTR may be the first to sixth transistors T1, T2, T3, T4, T5, and T6 described with reference to FIG. 3.

The semiconductor substrate SSUB may be a silicon substrate, a germanium substrate, or a silicon-germanium substrate. The semiconductor substrate SSUB may be a substrate doped with a first type impurity. A plurality of well regions WA may be located on the top surface of the semiconductor substrate SSUB. The plurality of well regions WA may be regions doped with a second type impurity. The second type impurity may be different from the aforementioned first type impurity. For example, if the first type impurity is a p-type impurity, the second type impurity may be an n-type impurity. Alternatively, if the first type impurity is an n-type impurity, the second type impurity may be a p-type impurity.

Each of the plurality of well regions WA includes a source region SA corresponding to the source electrode of the pixel transistor PTR, a drain region DA corresponding to the drain electrode thereof, and a channel region CH located between the source region SA and the drain region DA.

A lower insulating layer BINS may be located between a gate electrode GE and the well region WA. A side insulating layer SINS may be located on the side surface of the gate electrode GE. The side insulating layer SINS may be located on the lower insulating layer BINS.

Each of the source region SA and the drain region DA may be a region doped with the first type impurity. A gate electrode GE of the pixel transistor PTR may overlap the well region WA in the third direction DR3. The channel region CH may overlap the gate electrode GE in the third direction DR3. The source region SA may be located on one side of the gate electrode GE, and the drain region DA may be located on the other side of the gate electrode GE (e.g., in plan view).

Each of the plurality of well regions WA further includes a first low-concentration impurity region LDD1 located between the channel region CH and the source region SA, and a second low-concentration impurity region LDD2 located between the channel region CH and the drain region DA. The first low-concentration impurity region LDD1 may be a region having a lower impurity concentration than the source region SA due to the lower insulating layer BINS. The second low-concentration impurity region LDD2 may be a region having a lower impurity concentration than the drain region DA due to the lower insulating layer BINS. The distance between the source region SA and the drain region DA may increase due to the presence of the first low-concentration impurity region LDD1 and the second low-concentration impurity region LDD2. Therefore, the length of the channel region CH of each of the pixel transistors PTR may increase, so that the likelihood of punch-through and hot carrier phenomena that might be caused by a short channel may be reduced or prevented.

A first semiconductor insulating layer SINS1 may be located on the semiconductor substrate SSUB (as used herein, "on" may mean "above" or "over"). The first semiconductor insulating layer SINS1 may be formed of silicon carbonitride (SiCN) or a silicon oxide (SiOx)-based inorganic layer, but the present disclosure is not limited thereto.

A second semiconductor insulating layer SINS2 may be located on the first semiconductor insulating layer SINS1. The second semiconductor insulating layer SINS2 may be formed of a silicon oxide (SiOx)-based inorganic layer, but the present disclosure is not limited thereto.

The plurality of contact terminals CTE may be located on the second semiconductor insulating layer SINS2. Each of the plurality of contact terminals CTE may be connected to any one of the gate electrode GE, the source region SA, or the drain region DA of each of the pixel transistors PTR through holes penetrating the first semiconductor insulating layer SINS1 and the second semiconductor insulating layer SINS2. The plurality of contact terminals CTE may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them.

A third semiconductor insulating layer SINS3 may be located on the second semiconductor insulating layer SINS2 and a side surface of each of the plurality of contact terminals CTE. The top surface of each of the plurality of contact terminals CTE may be exposed without being covered by the third semiconductor insulating layer SINS3. The third semiconductor insulating layer SINS3 may be formed of a silicon oxide (SiOx)-based inorganic layer, but the present disclosure is not limited thereto.

The semiconductor substrate SSUB may be replaced with a glass substrate or a polymer resin substrate, such as polyimide. In this case, thin film transistors may be located on the glass substrate or the polymer resin substrate. The glass substrate may be a rigid substrate that does not bend, and the polymer resin substrate may be a flexible substrate that can be bent or curved.

The light-emitting element backplane EBP includes first to eighth conductive layers ML1, ML2, ML3, ML4, ML5, ML6, ML7, and ML8 and a plurality of vias VA1, VA2, VA3, VA4, VA5, VA6, VA7, VA8, VA9, and VA10. In addition, the light-emitting element backplane EBP includes a plurality of interlayer insulating layers INS1, INS2, INS3, INS4, INS5, INS6, INS7, INS8, and INS9 respectively located between the first to eighth conductive layers ML1, ML2, ML3, ML4, ML5, ML6, ML7, and ML8.

The first to eighth conductive layers ML1, ML2, ML3, ML4, ML5, ML6, ML7, and ML8 serve to connect the plurality of contact terminals CTE exposed from the semiconductor backplane SBP to thereby implement the circuit of the first sub-pixel SP1 shown in FIG. 3. That is, the first to sixth transistors T1, T2, T3, T4, T5, and T6 are merely formed on the semiconductor backplane SBP, and the connection of the first to sixth transistors T1, T2, T3, T4, T5, and T6 and the first and second capacitors C1 and C2 is accomplished through the first to eighth conductive layers ML1, ML2, ML3, ML4, ML5, ML6, ML7, and ML8. In addition, the connection between the drain region corresponding to the drain electrode of the fourth transistor T4, the source region corresponding to the source electrode of the fifth transistor T5, and the first electrode of the light-emitting element LE is also accomplished through the first to eighth conductive layers ML1, ML2, ML3, ML4, ML5, ML6, ML7, and ML8.

The first interlayer insulating layer INS1 may be located on the semiconductor backplane SBP. Each of the first vias VA1 may penetrate the first interlayer insulating layer INS1 to be connected to the contact terminal CTE exposed from the semiconductor backplane SBP. Each of the first conductive layers ML1 may be located on the first interlayer insulating layer INS1 and may be connected to the first via VA1.

The second interlayer insulating layer INS2 may be located on the first interlayer insulating layer INS1 and the first conductive layers ML1. Each of the second vias VA2 may penetrate the second interlayer insulating layer INS2, and may be connected to the exposed first conductive layer ML1. Each of the second conductive layers ML2 may be located on the second interlayer insulating layer INS2, and may be connected to the second via VA2.

The third interlayer insulating layer INS3 may be located on the second interlayer insulating layer INS2 and the second conductive layers ML2. Each of the third vias VA3 may penetrate the third interlayer insulating layer INS3, and may be connected to the exposed second conductive layer ML2. Each of the third conductive layers ML3 may be located on the third interlayer insulating layer INS3, and may be connected to the third via VA3.

A fourth interlayer insulating layer INS4 may be located on the third interlayer insulating layer INS3 and the third conductive layers ML3. Each of the fourth vias VA4 may penetrate the fourth interlayer insulating layer INS4, and may be connected to the exposed third conductive layer ML3. Each of the fourth conductive layers ML4 may be located on the fourth interlayer insulating layer INS4, and may be connected to the fourth via VA4.

A fifth interlayer insulating layer INS5 may be located on the fourth interlayer insulating layer INS4 and the fourth conductive layers ML4. Each of the fifth vias VA5 may penetrate the fifth interlayer insulating layer INS5, and may be connected to the exposed fourth conductive layer ML4. Each of the fifth conductive layers ML5 may be located on the fifth interlayer insulating layer INS5, and may be connected to the fifth via VA5.

A sixth interlayer insulating layer INS6 may be located on the fifth interlayer insulating layer INS5 and the fifth conductive layers ML5. Each of the sixth vias VA6 may penetrate the sixth interlayer insulating layer INS6, and may be connected to the exposed fifth conductive layer ML5. Each of the sixth conductive layers ML6 may be located on the sixth interlayer insulating layer INS6, and may be connected to the sixth via VA6.

A seventh interlayer insulating layer INS7 may be located on the sixth interlayer insulating layer INS6 and the sixth conductive layers ML6. Each of the seventh vias VA7 may penetrate the seventh interlayer insulating layer INS7, and may be connected to the exposed sixth conductive layer ML6. Each of the seventh conductive layers ML7 may be located on the seventh interlayer insulating layer INS7, and may be connected to the seventh via VA7.

An eighth interlayer insulating layer INS8 may be located on the seventh interlayer insulating layer INS7 and the seventh conductive layers ML7. Each of the eighth vias VA8 may penetrate the eighth interlayer insulating layer INS8, and may be connected to the exposed seventh conductive layer ML7. Each of the eighth conductive layers ML8 may be located on the eighth interlayer insulating layer INS8, and may be connected to the eighth via VA8.

The first to eighth conductive layers ML1, ML2, ML3, ML4, ML5, ML6, ML7, and ML8 and the first to eighth vias VA1, VA2, VA3, VA4, VA5, VA6, VA7, and VA8 may be formed of substantially the same material. The first to eighth conductive layers ML1, ML2, ML3, ML4, ML5, ML6, ML7, and ML8 and the first to eighth vias VA1, VA2, VA3, VA4, VA5, VA6, VA7, and VA8 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. The first to eighth vias VA1, VA2, VA3, VA4, VA5, VA6, VA7, and VA8 may be made of substantially the same material. First to eighth interlayer insulating layers INS1, INS2, INS3, INS4, INS5, INS6, INS7, and INS8 may be formed of a silicon oxide (SiOx)-based inorganic layer, but the present disclosure is not limited thereto.

The thicknesses of the first conductive layer ML1, the second conductive layer ML2, the third conductive layer ML3, the fourth conductive layer ML4, the fifth conductive layer ML5, and the sixth conductive layer ML6 may be larger than the thicknesses of the first via VA1, the second via VA2, the third via VA3, the fourth via VA4, the fifth via VA5, and the sixth via VA6, respectively. The thickness of each of the second conductive layer ML2, the third conductive layer ML3, the fourth conductive layer ML4, the fifth conductive layer ML5, and the sixth conductive layer ML6 may be larger than the thickness of the first conductive layer ML1. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be substantially the same. For example, the thickness of the first conductive layer ML1 may be approximately 1360 Å, the thickness of each of the second conductive layer ML2, the third conductive layer ML3, the fourth conductive layer ML4, the fifth conductive layer ML5, and the sixth conductive layer ML6 may be approximately 1440 Å, and the thickness of each of the first via VA1, the second via VA2, the third via VA3, the fourth via VA4, the fifth via VA5, and the sixth via VA6 may be approximately 1150 Å.

The thickness of each of the seventh conductive layer ML7 and the eighth conductive layer ML8 may be larger than the thickness of the first conductive layer ML1, the thickness of the second conductive layer ML2, the thickness of the third conductive layer ML3, the thickness of the fourth conductive layer ML4, the thickness of the fifth conductive layer ML5, and the thickness of the sixth conductive layer ML6. The thickness of the seventh conductive layer ML7 and the thickness of the eighth conductive layer ML8 may be larger than the thickness of the seventh via VA7 and the thickness of the eighth via VA8, respectively. The thickness of each of the seventh via VA7 and the eighth via VA8 may be larger than the thickness of the first via VA1, the thickness of the second via VA2, the thickness of the third via VA3, the thickness of the fourth via VA4, the thickness of the fifth via VA5, and the thickness of the sixth via VA6. The thickness of the seventh conductive layer ML7 and the thickness of the eighth conductive layer ML8 may be substantially the same. For example, the thickness of each of the seventh conductive layer ML7 and the eighth conductive layer ML8 may be approximately 9000 Å. The thickness of each of the seventh via VA7 and the eighth via VA8 may be approximately 6000 Å.

A ninth interlayer insulating layer INS9 may be located on the eighth interlayer insulating layer INS8 and the eighth conductive layers ML8. The ninth insulating layer INS9 may be formed of a silicon oxide (SiOx)-based inorganic layer, but the present disclosure is not limited thereto.

Each of the ninth vias VA9 may penetrate the ninth interlayer insulating layer INS9, and may be connected to the exposed eighth conductive layer ML8. The ninth vias VA9 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. The thickness of the ninth via VA9 may be approximately 16500 Å.

The display element layer EML may be located on the light-emitting element backplane EBP. The display element layer EML includes the reflective electrode layer RL, a tenth interlayer insulating layer INS10, the light-emitting elements LE, the pixel-defining film PDL, and a plurality of trenches TRC. Each of the light-emitting elements LE includes a first electrode AND, the light-emitting stack IL, and a second electrode CAT.

The reflective electrode layer RL may be located on the ninth interlayer insulating layer INS9. The reflective electrode layer RL may include at least one reflective electrode RL1, RL2, RL3, and RL4. For example, the reflective electrode layer RL may include the first to fourth reflective electrodes RL1, RL2, RL3, and RL4 and a step layer STPL, as illustrated in FIG. 7.

Each of the first reflective electrodes RL1 may be located on the ninth interlayer insulating layer INS9, and may be connected to the ninth via VA9. The first reflective electrodes RL1 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. The first reflective electrode RL1 may include titanium nitride (TiN).

The second reflective electrodes RL2 may be located on the first reflective electrodes RL1. The second reflective electrodes RL2 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. For example, the second reflective electrodes RL2 may include aluminum.

In the first sub-pixel SP1, the step layer STPL may be located on the second reflective electrode RL2. The step layer STPL may be omitted from the second sub-pixel SP2 and the third sub-pixel SP3. To advantageously reflect the light of the first color emitted from a first stack layer IL1 of the first sub-pixel SP1, the thickness of the step layer STPL may be set in consideration of the wavelength of the light of the first color and the distance from the first stack layer IL1 to the fourth reflective electrode RL4. The step layer STPL may be formed of silicon carbonitride (SiCN) or a silicon oxide (SiOx)-based inorganic layer, but the present disclosure is not limited thereto. The thickness of the step layer STPL may be about 400 Å.

In the first sub-pixel SP1, the third reflective electrode RL3 may be located on the second reflective electrode RL2 and the step layer STPL. In the second sub-pixel SP2 and the third sub-pixel SP3, the third reflective electrode RL3 may be located on the second reflective electrode RL2. The third reflective electrodes RL3 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. For example, the third reflective electrodes RL3 may include titanium nitride (TiN).

In one or more embodiments, at least one of the first reflective electrode RL1, the second reflective electrode RL2, or the third reflective electrode RL3 may be omitted.

The fourth reflective electrodes RL4 may be respectively located on the third reflective electrodes RL3. The fourth reflective electrodes RL4 may reflect light from first to third stack layers IL1, IL2, and IL3. The fourth reflective electrodes RL4 may include a metal having high reflectivity to advantageously reflect the light. The fourth reflective electrodes RL4 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. For example, the fourth reflective electrodes RL4 may include titanium (Ti).

A tenth interlayer insulating layer INS10 may be located on the ninth interlayer insulating layer INS9 and the fourth reflective electrodes RL4. The tenth interlayer insulating layer INS 10 may be an optical auxiliary layer through which light reflected by the reflective electrode layer RL passes, among light emitted from the light-emitting elements LE. The tenth insulating layer INS10 may be formed of a silicon oxide (SiOx)-based inorganic layer, but the present disclosure is not limited thereto.

Each of the tenth vias VA10 may penetrate the tenth interlayer insulating layer INS10, and may be connected to the exposed fourth reflective electrodes RL4. The tenth vias VA10 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. Due to the presence of the step layer STPL, the thickness of the tenth via VA10 in the first sub-pixel SP1 may be less than the thickness of the tenth via VA10 in each of the second sub-pixel SP2 and the third sub-pixel SP3. For example, the thickness of the tenth via VA10 in the first sub-pixel SP1 may be about 800 Å, and the thickness of the tenth via VA10 in each of the second sub-pixel SP2 and the third sub-pixel SP3 may be about 1200 Å.

In at least one sub-pixel of the first sub-pixel SP1, the second sub-pixel SP2, or the third sub-pixel SP3, to adjust the resonance distance of the light emitted from the light-emitting elements LE, the step layer STPL may be omitted from at least one sub-pixel of the first sub-pixel SP1, the second sub-pixel SP2, or the third sub-pixel SP3. Alternatively, the thickness of the step layer STPL may be different in the first sub-pixel SP1, the second sub-pixel SP2, and the third sub-pixel SP3. Due to the presence or thickness difference of the step layer STPL, the distance between the first electrode AND and the reflective electrode layer RL may be different in each of the first sub-pixel SP1, the second sub-pixel SP2, and the third sub-pixel SP3. That is, to adjust the distance from the reflective electrode layer RL to the second electrode CAT according to the main wavelength of light respectively emitted from each of the first sub-pixel SP1, the second sub-pixel SP2, and the third sub-pixel SP3, the presence or absence of the step layer STPL or the thickness of the step layer STPL may be determined in each of the first sub-pixel SP1, the second sub-pixel SP2, and the third sub-pixel SP3. FIG. 7 illustrates that the distance between the first electrode AND and the reflective electrode layer RL in the first sub-pixel SP1 is less than the distance between the first electrode AND and the reflective electrode layer RL in the second sub-pixel SP2 and is less than the distance between the first electrode AND and the reflective electrode layer RL in the third sub-pixel SP3, but the present disclosure is not limited thereto.

Each of the tenth vias VA10 may penetrate the tenth interlayer insulating layer INS10 in the second sub-pixel SP2 and the third sub-pixel SP3, and may be connected to the exposed fourth reflective electrode layer RL4. The tenth vias VA10 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. The thickness of the tenth via VA10 in the second sub-pixel SP2 may be less than the thickness of the tenth via VA10 in the third sub-pixel SP3.

The first electrode AND of each of the light-emitting elements LE may be located on the tenth interlayer insulating layer INS10, and may be connected to the tenth via VA10. The first electrode AND of each of the light-emitting elements LE may be connected to the drain region DA or source region SA of the pixel transistor PTR through the tenth via VA10, the first to fourth reflective electrodes RL1, RL2, RL3, and RL4, the first to ninth vias VA1 to VA9, the first to eighth conductive layers ML1, ML2, ML3, ML4, ML5, ML6, ML7, and ML8, and the contact terminal CTE. The first electrode AND of each of the light-emitting elements LE may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. For example, the first electrode AND of each of the light-emitting elements LE may be titanium nitride (TiN).

The pixel-defining film PDL may be located on a part of the first electrode AND of each of the light-emitting elements LE. The pixel-defining film PDL may cover the edge of the first electrode AND of each of the light-emitting elements LE. The pixel-defining film PDL may serve to partition the first light-emitting areas EA1, the second light-emitting areas EA2, and the third light-emitting areas EA3.

The first light-emitting area EA1 may be defined as an area in which the first electrode AND, the light-emitting stack IL, and the second electrode CAT are sequentially stacked in the first sub-pixel SP1 to emit light. The second light-emitting area EA2 may be defined as an area in which the first electrode AND, the light-emitting stack IL, and the second electrode CAT are sequentially stacked in the second sub-pixel SP2 to emit light. The third light-emitting area EA3 may be defined as an area in which the first electrode AND, the light-emitting stack IL, and the second electrode CAT are sequentially stacked in the third sub-pixel SP3 to emit light.

The pixel-defining film PDL may include first to third pixel-defining films PDL1, PDL2, and PDL3. The first pixel-defining film PDL1 may be located on the edge of the first electrode AND of each of the light-emitting elements LE, the second pixel-defining film PDL2 may be located on the first pixel-defining film PDL1, and the third pixel-defining film PDL3 may be located on the second pixel-defining film PDL2. The first pixel-defining film PDL1, the second pixel-defining film PDL2, and the third pixel-defining film PDL3 may be formed of a silicon oxide (SiOx)-based inorganic layer, but the present disclosure is not limited thereto. The first pixel-defining film PDL1, the second pixel-defining film PDL2, and the third pixel-defining film PDL3 may each have a thickness of about 500 Å.

When the first pixel-defining film PDL1, the second pixel-defining film PDL2, and the third pixel-defining film PDL3 are formed as one pixel-defining film, the height of the one pixel-defining film increases, so that a first encapsulation inorganic layer TFE1 may be cut off due to step coverage. Step coverage refers to the ratio of the degree of thin film coated on an inclined portion to the degree of thin film coated on a flat portion. The lower the step coverage, the more likely it is that the thin film will be cut off at inclined portions.

Therefore, to reduce or prevent the likelihood of the first encapsulation inorganic layer TFE1 being cut off due to the step coverage, the first pixel-defining film PDL1, the second pixel-defining film PDL2, and the third pixel-defining film PDL3 may have a cross-sectional structure having a stepped portion. For example, the width of the first pixel-defining film PDL1 may be greater than the width of the second pixel-defining film PDL2 and the width of the third pixel-defining film PDL3. Also for example, the width of the second pixel-defining film PDL2 may be greater than the width of the third pixel-defining film PDL3. The width of the first pixel-defining film PDL1 refers to the horizontal length of the first pixel-defining film PDL1 defined in the first direction DR1 and the second direction DR2.

Each of the plurality of trenches TRC may penetrate the first pixel-defining film PDL1, the second pixel-defining film PDL2, and the third pixel-defining film PDL3. The tenth interlayer insulating layer INS10 may be partially recessed at each of the plurality of trenches TRC.

At least one trench TRC may be located between adjacent sub-pixels SP1, SP2, and SP3. Although FIG. 7 illustrates that two trenches TRC are located between adjacent sub-pixels SP1, SP2, and SP3, the present disclosure is not limited thereto.

The light-emitting stack IL may include a plurality of stack layers. FIG. 7 illustrates that the light-emitting stack IL has a three-tandem structure including the first stack layer IL1, the second stack layer IL2, and the third stack layer IL3, but the present disclosure is not limited thereto. For example, the light-emitting stack IL may have a two-tandem structure including two stack layers.

In the three-tandem structure, the light-emitting stack IL may have a tandem structure including a plurality of stack layers IL1, IL2, and IL3 that emit different light colors. For example, the light-emitting stack IL may include the first stack layer IL1 that emits light of the first color, the second stack layer IL2 that emits light of the third color, and the third stack layer IL3 that emits light of the second color. The first stack layer IL1, the second stack layer IL2, and the third stack layer IL3 may be sequentially stacked.

The first stack layer IL1 may have a structure in which a first hole transport layer, a first organic light-emitting layer that emits light of the first color, and a first electron transport layer are sequentially stacked. The second stack layer IL2 may have a structure in which a second hole transport layer, a second organic light-emitting layer that emits light of the third color, and a second electron transport layer are sequentially stacked. The third stack layer IL3 may have a structure in which a third hole transport layer, a third organic light-emitting layer that emits light of the second color, and a third electron transport layer are sequentially stacked.

A first charge generation layer for supplying charges to the second stack layer IL2 and for supplying electrons to the first stack layer IL1 may be located between the first stack layer IL1 and the second stack layer IL2. The first charge generation layer may include an N-type charge generation layer that supplies electrons to the first stack layer IL1 and a P-type charge generation layer that supplies holes to the second stack layer IL2. The N-type charge generation layer may include a dopant of a metal material.

A second charge generation layer for supplying charges to the third stack layer IL3 and for supplying electrons to the second stack layer IL2 may be located between the second stack layer IL2 and the third stack layer IL3. The second charge generation layer may include an N-type charge generation layer that supplies electrons to the second stack layer IL2 and a P-type charge generation layer that supplies holes to the third stack layer IL3.

The first stack layer IL1 may be located on the first electrodes AND and the pixel-defining film PDL, and may be located on the bottom surface of each trench TRC. Due to the trench TRC, the first stack layer IL1 may be cut off between adjacent sub-pixels SP1, SP2, and SP3. The second stack layer IL2 may be located on the first stack layer IL1. Due to the trench TRC, the second stack layer IL2 may be cut off between adjacent sub-pixels SP1, SP2, and SP3. A cavity ESS or an empty space may be located between the first stack layer IL1 and the second stack layer IL2. The third stack layer IL3 may be located on the second stack layer IL2. The third stack layer IL3 is not cut off by the trench TRC, and may be located to cover the second stack layer IL2 in each of the trenches TR (e.g., to cover edges of the second stack layer IL2 in each of the trenches TR). That is, in the three-tandem structure, each of the plurality of trenches TRC may be a structure for cutting off the first to second stack layers IL1 and IL2, the first charge generation layer, and the second charge generation layer of the display element layer EML between the sub-pixels SP1, SP2, and SP3 adjacent to each other. In addition, in the two-tandem structure, each of the plurality of trenches TRC may be a structure for cutting off the charge generation layer and the lower stack layer located between the lower stack layer and the upper stack layer.

To stably cut off the first and second stack layers IL1 and IL2 of the display element layer EML between adjacent sub-pixels SP1, SP2, and SP3, the height of each of the plurality of trenches TRC may be greater than the height of the pixel-defining film PDL. The height of each of the plurality of trenches TRC refers to the length of each of the plurality of trenches TRC in the third direction DR3. The height of the pixel-defining film PDL refers to the length of the pixel-defining film PDL in the third direction DR3. To cut off the first to third stack layers IL1, IL2, and IL3 of the display element layer EML between the neighboring sub-pixels SP1, SP2, and SP3, another structure may exist instead of the trench TRC. For example, instead of the trench TRC, a reverse tapered partition wall may be located on the pixel-defining film PDL.

The number of the stack layers IL1, IL2, and IL3 that emit different light colors is not limited to that shown in FIG. 7. For example, the light-emitting stack IL may include two stack layers. In this case, one of the two stack layers may be substantially the same as the first stack layer IL1, and the other stack layer may include a second hole transport layer, a second organic light-emitting layer, a third organic light-emitting layer, and a second electron transport layer. In this case, a charge generation layer for supplying electrons to one stack layer and supplying charges to the other stack layer may be located between the two stack layers.

In addition, FIG. 7 illustrates that the first to third stack layers IL1, IL2, and IL3 are all located in the first light-emitting area EA1, the second light-emitting area EA2, and the third light-emitting area EA3, but the present disclosure is not limited thereto. For example, the first stack layer IL1 may be located in the first light-emitting area EA1, and may be omitted from the second light-emitting area EA2 and the third light-emitting area EA3. Furthermore, the second stack layer IL2 may be located in the second light-emitting area EA2 and may be omitted from the first light-emitting area EA1 and the third light-emitting area EA3. Further, the third stack layer IL3 may be located in the third light-emitting area EA3 and may be omitted from the first light-emitting area EA1 and the second light-emitting area EA2. In this case, first to third color filters CF1, CF2, and CF3 of the optical layer OPL may be omitted.

The second electrode CAT may be located on the third stack layer IL3. The second electrode CAT may be located on the third stack layer IL3 in each of the plurality of trenches TRC. The second electrode CAT may be formed of a transparent conductive material (TCO), such as ITO or IZO that can transmit light or a semi-transmissive conductive material, such as magnesium (Mg), silver (Ag), or an alloy of Mg and Ag. When the second electrode CAT is formed of a semi-transmissive conductive material, the light emission efficiency may be improved in each of the first to third sub-pixels SP1, SP2, and SP3 due to a micro-cavity effect.

The encapsulation layer TFE may be located on the display element layer EML. The encapsulation layer TFE may include at least one inorganic layer TFE1 and TFE3 to reduce or prevent permeation of oxygen or moisture into the display element layer EML. In addition, the encapsulation layer TFE may include at least one organic layer to protect the display element layer EML from foreign substances, such as dust. For example, the encapsulation layer TFE may include a first encapsulation inorganic layer TFE1, an encapsulation organic layer TFE2, and a second encapsulation inorganic layer TFE3.

The first encapsulation inorganic layer TFE1 may be located on the second electrode CAT, the encapsulation organic layer TFE2 may be located on the first encapsulation inorganic layer TFE1, and the second encapsulation inorganic layer TFE3 may be located on the encapsulation organic layer TFE2. The first encapsulation inorganic layer TFE1 and the second encapsulation inorganic layer TFE3 may be formed of multiple layers in which one or more inorganic layers of silicon nitride (SiNx), silicon oxynitride (SiON), silicon oxide (SiOx), titanium oxide (TiOx), or aluminum oxide (AlOx) layers are alternately stacked. The encapsulation organic layer TFE2 may be a monomer. Alternatively, the encapsulation organic layer TFE2 may be an organic layer, such as acryl resin, epoxy resin, phenolic resin, polyamide resin, polyimide resin or the like.

An adhesive layer ADL may be a layer for bonding the encapsulation layer TFE to the optical layer OPL. The adhesive layer ADL may be a double-sided adhesive. In addition, the adhesive layer ADL may be a transparent adhesive, such as a transparent adhesive or a transparent adhesive resin.

The optical layer OPL includes a plurality of color filters CF1, CF2, and CF3, a plurality of lenses LNS, and a filling layer FIL. The plurality of color filters CF1, CF2, and CF3 may include the first to third color filters CF1, CF2, and CF3. The first to third color filters CF1, CF2, and CF3 may be located on the adhesive layer ADL.

The first color filter CF1 may overlap the first light-emitting area EA1 of the first sub-pixel SP1. The first color filter CF1 may transmit light of the first color (e.g., light of a blue wavelength band). The blue wavelength band may be about 370 nm to about 460 nm. Thus, the first color filter CF1 may transmit light of the first color among light emitted from the first light-emitting area EA1.

The second color filter CF2 may overlap the second light-emitting area EA2 of the second sub-pixel SP2. The second color filter CF2 may transmit light of the second color (e.g., light of a green wavelength band). The green wavelength band may be about 480 nm to about 560 nm. Thus, the second color filter CF2 may transmit light of the second color among light emitted from the second light-emitting area EA2.

The third color filter CF3 may overlap the third light-emitting area EA3 of the third sub-pixel SP3. The third color filter CF3 may transmit light of the third color (e.g., light of a red wavelength band). The red wavelength band may be about 600 nm to about 750 nm. Thus, the third color filter CF3 may transmit light of the third color among light emitted from the third light-emitting area EA3.

The plurality of lenses LNS may be located on the first color filter CF1, the second color filter CF2, and the third color filter CF3, respectively. Each of the plurality of lenses LNS may be a structure for increasing a ratio of light directed to the front of the display device 10. Each of the plurality of lenses LNS may have a cross-sectional shape that is convex in an upward direction.

The filling layer FIL may be located on the plurality of lenses LNS. The filling layer FIL may have a refractive index (e.g., predetermined refractive index) such that light travels in the third direction DR3 at an interface between the filling layer FIL and the plurality of lenses LNS. Further, the filling layer FIL may be a planarization layer. The filling layer FIL may be an organic layer, such as acrylic resin, epoxy resin, phenolic resin, polyamide resin, or polyimide resin.

The cover layer CVL may be located on the filling layer FIL. The cover layer CVL may be a glass substrate or a polymer resin. When the cover layer CVL is a glass substrate, it may be attached onto the filling layer FIL. In this case, the filling layer FIL may serve to bond the cover layer CVL. When the cover layer CVL is a glass substrate, it may serve as an encapsulation substrate. When the cover layer CVL is a polymer resin, it may be directly applied onto the filling layer FIL.

The polarizing plate may be located on one surface of the cover layer CVL. The polarizing plate may be a structure for reducing or preventing visibility degradation caused by reflection of external light. The polarizing plate may include a linear polarizing plate and a phase retardation film. For example, the phase retardation film may be a λ/4 plate (quarter-wave plate), but the present disclosure is not limited thereto. However, if visibility degradation caused by reflection of external light is sufficiently overcome by the first to third color filters CF1, CF2, and CF3, the polarizing plate may be omitted.

As illustrated in FIG. 7, by forming the light-emitting element backplane EBP and the display element layer EML on the semiconductor substrate SSUB on which a plurality of transistors are formed, the transistors and transistor wirings are not formed in the same plane as the light-emitting areas EA1, EA2 and EA3. As such, the light-emitting areas maybe formed closer together and the size of the plurality of pixels PX may be greatly reduced, so that the display device 10 that displays high-resolution images may be provided.

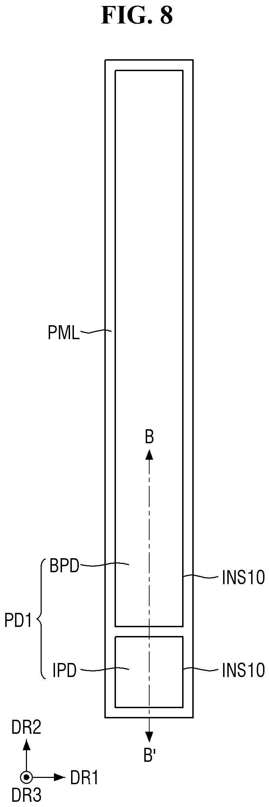

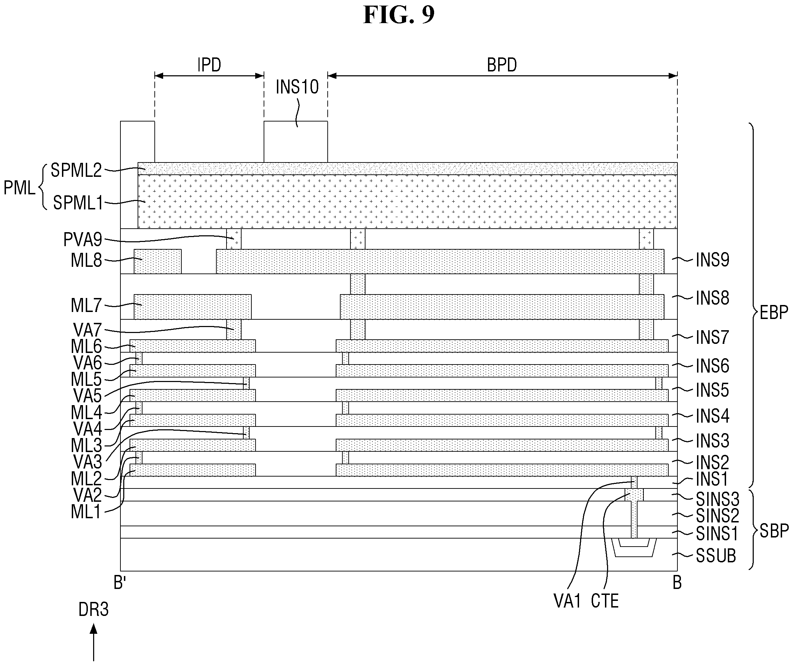

FIG. 8 is a layout diagram illustrating the first pad of the first pad portion of FIG. 4. FIG. 9 is a cross-sectional view illustrating a display panel taken along the line B-B' of FIG. 8.

Referring to FIGS. 8 and 9, each of the first pads PD1 includes a first sub-pad BPD and a second sub-pad IPD in which a pad conductive layer PML is partitioned by the tenth insulating layer INS10. Both the first sub-pad BPD and the second sub-pad IPD may be electrically connected to a pad or bump of the circuit board 300 through a conductive adhesive. In addition, the second sub-pad IPD may be a pad connected to a jig or probe pin during an inspection process or connected to a circuit board for inspection.

The area of the first sub-pad BPD may be larger than the area of the second sub-pad IPD. The length of the first sub-pad BPD in the first direction DR1 may be substantially the same as the length of the second sub-pad IPD in the first direction DR1. The length of the first sub-pad BPD in the second direction DR2 may be greater than the length of the second sub-pad IPD in the second direction DR2.

The pad conductive layer PML may include a first sub-pad conductive layer SPML1 and a second sub-pad conductive layer SPML2. The first sub-pad conductive layer SPML1 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. The second sub-pad conductive layer SPML2 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. For example, the first sub-pad conductive layer SPML1 may be made of aluminum (Al), and may have a thickness of approximately 12,000 Å. In addition, the second sub-pad conductive layer SPML2 may be made of titanium nitride (TiN), and may have a thickness of approximately 600 Å. The thickness of the pad conductive layer PML may be greater than the thickness of the reflective electrode layer RL.

A portion of the top surface of the second sub-pad conductive layer SPML2 corresponding to the first sub-pad BPD may be exposed without being covered by the tenth insulating layer INS10. The top surface of the second sub-pad conductive layer SPML2 corresponding to the second sub-pad IPD may be exposed without being covered by the tenth insulating layer INS10. The first sub-pad conductive layer SPML1 may be connected to a pad via PVA9 that penetrates the ninth insulating layer INS9 to be connected to the eighth conductive layer ML8.

As illustrated in FIGS. 8 and 9, because the pad conductive layer PML of the first sub-pad BPD and the pad conductive layer PML of the second sub-pad IPD are formed integrally, if the pad conductive layer PML of the second sub-pad IPD is damaged or broken during an inspection process, the pad conductive layer PML of the first sub-pad BPD may also be damaged or broken. Accordingly, it may be suitable to separate or distinguish the pad conductive layer PML of the second sub-pad IPD and the pad conductive layer PML of the first sub-pad BPD used in an inspection process.

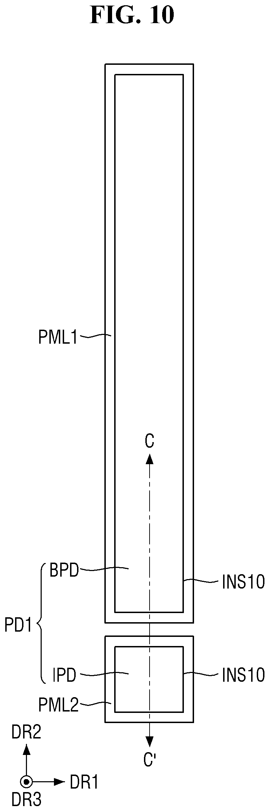

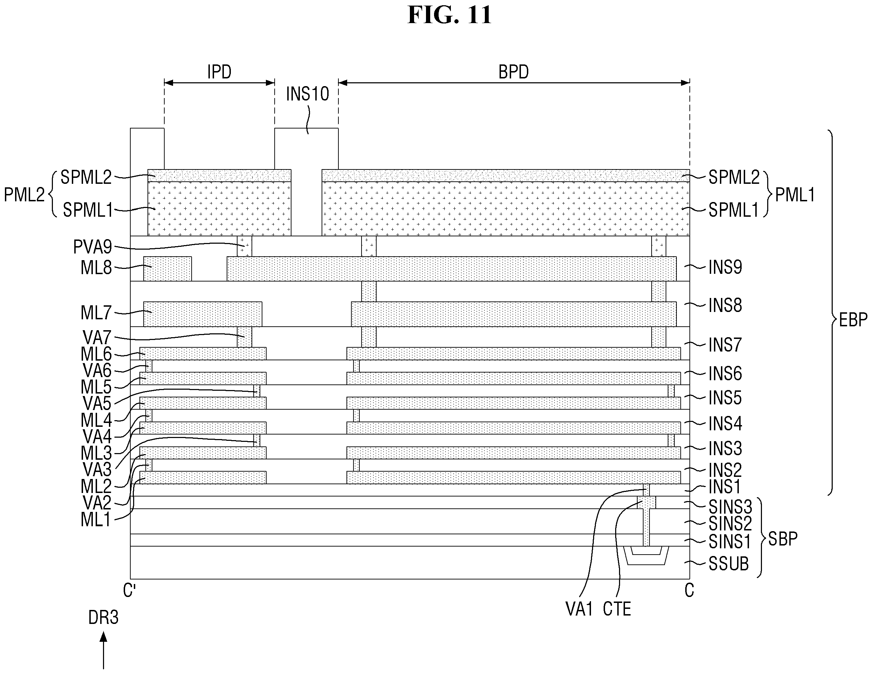

FIG. 10 is a layout diagram illustrating yet another example of the first pad of the first pad portion of FIG. 4. FIG. 11 is a cross-sectional view illustrating a display panel taken along the line C-C' of FIG. 10.

Referring to FIGS. 10 and 11, each of the first pads PD1 includes the first sub-pad BPD made of the first pad conductive layer PML1, and the second sub-pad IPD made of a second pad conductive layer PML2. Both the first sub-pad BPD and the second sub-pad IPD may be electrically connected to a pad or bump of the circuit board 300 through a conductive adhesive. In addition, the second sub-pad IPD may be a pad connected to a jig or probe pin during an inspection process or connected to a circuit board for inspection.

The area of the first sub-pad BPD may be larger than the area of the second sub-pad IPD. The length of the first sub-pad BPD in the first direction DR1 may be substantially the same as the length of the second sub-pad IPD in the first direction DR1. The length of the first sub-pad BPD in the second direction DR2 may be greater than the length of the second sub-pad IPD in the second direction DR2.

Each of the first pad conductive layer PML1 and the second pad conductive layer PML2 may include the first sub-pad conductive layer SPML1 and the second sub-pad conductive layer SPML2. The first sub-pad conductive layer SPML1 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. The second sub-pad conductive layer SPML2 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. For example, the first sub-pad conductive layer SPML1 may be made of aluminum (Al) and may have a thickness of approximately 12,000 Å. In addition, the second sub-pad conductive layer SPML2 may be made of titanium nitride (TiN) and may have a thickness of approximately 600 Å. The thickness of each of the first pad conductive layer PML1 and the second pad conductive layer PML2 may be greater than the thickness of the reflective electrode layer RL.

A portion of the top surface of the second sub-pad conductive layer SPML2 of the first pad conductive layer PML1 corresponding to the first sub-pad BPD may be exposed without being covered by the tenth insulating layer INS10. The top surface of the second sub-pad conductive layer SPML2 of the second pad conductive layer PML2 corresponding to the second sub-pad IPD may be exposed without being covered by the tenth insulating layer INS10. The first sub-pad conductive layer SPML1 may be connected to a pad via PVA9 that penetrates the ninth insulating layer INS9 to be connected to the eighth conductive layer ML8.

The first pad conductive layer PML1 and the second pad conductive layer PML2 are connected to the same eighth conductive layer ML8 through the pad via PVA9. Accordingly, the first pad conductive layer PML1 and the second pad conductive layer PML2 may have substantially the same potential.

As illustrated in FIGS. 10 and 11, because the first pad conductive layer PML1 of the first sub-pad BPD and the second pad conductive layer PML2 of the second sub-pad IPD are separated or distinguished from each other, even if the second pad conductive layer PML2 of the second sub-pad IPD is damaged or broken by the jig or probe pin in an inspection process, the first pad conductive layer PML1 of the first sub-pad BPD may not be damaged or broken.

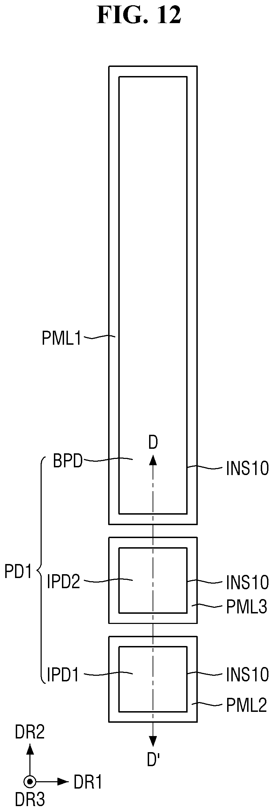

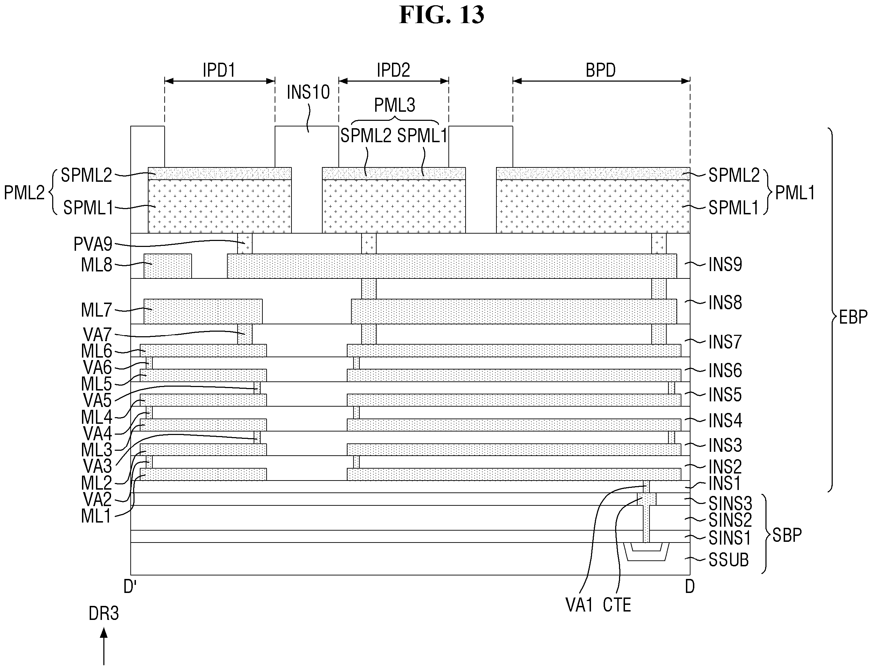

FIG. 12 is a layout diagram illustrating yet another example of the first pad of the first pad portion of FIG. 4. FIG. 13 is a cross-sectional view illustrating a display panel taken along the line D-D' of FIG. 12.

Referring to FIGS. 12 and 13, each of the first pads PD1 includes the first sub-pad BPD formed of the first pad conductive layer PML1, the second sub-pad IPD1 formed of the second pad conductive layer PML2, and a third sub-pad IPD2 formed of a third pad conductive layer PML3. The first sub-pad BPD, the second sub-pad IPD1, and the third sub-pad IPD2 may all be electrically connected to a pad or bump of the circuit board 300 through a conductive adhesive. In addition, the second sub-pad IPD1 and the third sub-pad IPD2 may be pads connected to a jig or probe pin during an inspection process or connected to a circuit board for inspection. The second sub-pad IPD1 may be a pad for inspecting whether the scan driver 610, the emission driver 620, and the data driver 700 are operating normally, and the third sub-pad IPD2 may be a pad for performing visual inspection of the display image of the display area DA of the display panel 100.

The area of the first sub-pad BPD may be larger than the area of the second sub-pad IPD1 and the area of the third sub-pad IPD2. The length of the first sub-pad BPD in the first direction DR1 may be substantially the same as the length of the second sub-pad IPD1 in the first direction DR1 and the length of the third sub-pad IPD2 in the first direction DR1. The length of the first sub-pad BPD in the second direction DR2 may be greater than the length of the second sub-pad IPD1 in the second direction DR2 and the length of the third sub-pad IPD2 in the second direction DR2.

Each of the first pad conductive layer PML1, the second pad conductive layer PML2, and the third pad conductive layer PML3 may include the first sub-pad conductive layer SPML1 and the second sub-pad conductive layer SPML2. The first sub-pad conductive layer SPML1 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. The second sub-pad conductive layer SPML2 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them. For example, the first sub-pad conductive layer SPML1 may be made of aluminum (Al), and may have a thickness of approximately 12,000 Å. In addition, the second sub-pad conductive layer SPML2 may be made of titanium nitride (TiN), and may have a thickness of approximately 600 Å. The thickness of each of the first pad conductive layer PML1, the second pad conductive layer PML2, and the third pad conductive layer PML3 may be greater than the thickness of the reflective electrode layer RL.

A portion of the top surface of the second sub-pad conductive layer SPML2 of the first pad conductive layer PML1 corresponding to the first sub-pad BPD may be exposed without being covered by the tenth insulating layer INS10. The top surface of the second sub-pad conductive layer SPML2 of the second pad conductive layer PML2 corresponding to the second sub-pad IPD1 may be exposed without being covered by the tenth insulating layer INS10. The top surface of the second sub-pad conductive layer SPML2 of the second pad conductive layer PML2 corresponding to the third sub-pad IPD2 may be exposed without being covered by the tenth insulating layer INS10. The first sub-pad conductive layer SPML1 may be connected to a pad via PVA9 that penetrates the ninth insulating layer INS9 to be connected to the eighth conductive layer ML8.

The first pad conductive layer PML1, the second pad conductive layer PML2, and the third pad conductive layer PML3 are connected to the same eighth conductive layer ML8 through the pad via PVA9. Accordingly, the first pad conductive layer PML1, the second pad conductive layer PML2, and the third pad conductive layer PML3 may have substantially the same potential.

As illustrated in FIGS. 12 and 13, the first pad conductive layer PML1 of the first sub-pad BPD, the second pad conductive layer PML2 of the second sub-pad IPD1, and the third pad conductive layer PML3 of the third sub-pad IPD2 are separated or distinguished from each other, so that the first pad conductive layer PML1 of the first sub-pad BPD may not be damaged or broken even if the second pad conductive layer PML2 of the second sub-pad IPD1 and/or the third pad conductive layer PML3 of the third sub-pad IPD2 are damaged or broken by a jig or probe pin in an inspection process.

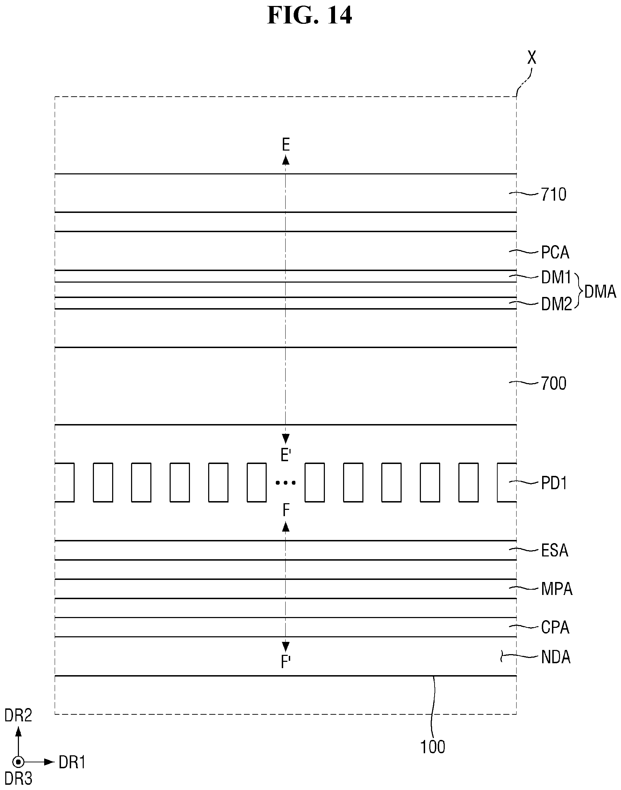

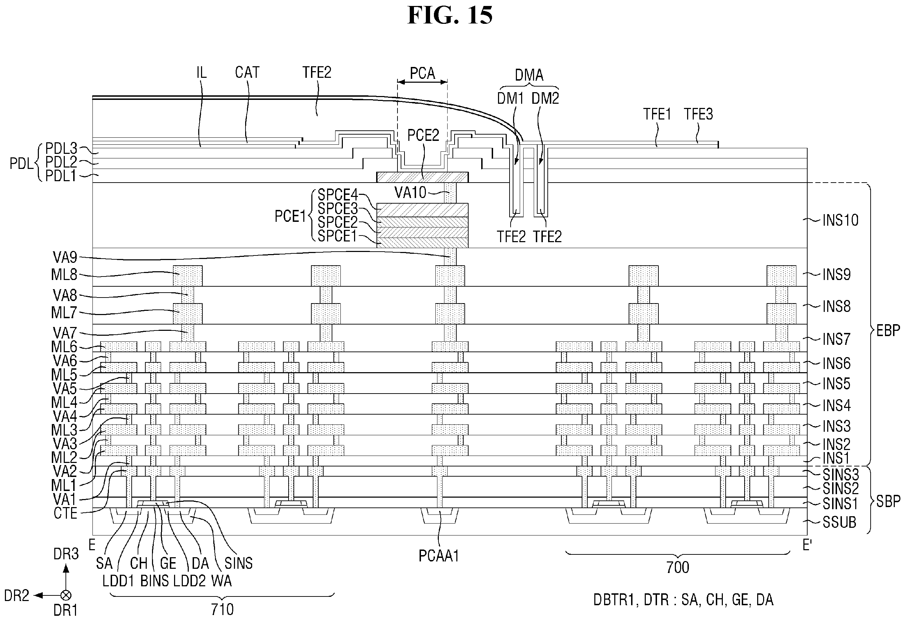

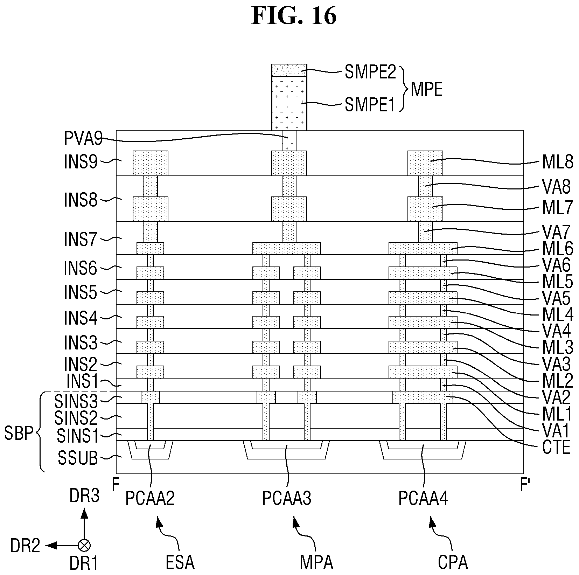

FIG. 14 is a layout diagram showing in detail an area X of FIG. 4. FIG. 15 is a cross-sectional view illustrating a display panel taken along the line E-E' of FIG. 14. FIG. 16 is a cross-sectional view illustrating a display panel taken along the line F-F' of FIG. 14.

Area X in FIG. 4 may be an area located on the third side of the display area DA. FIGS. 14 to 16 illustrate the first distribution circuit 710, the power connection portion PCA, the dam portion DMA, the data driver 700, the first pad portion PDA1, the electrostatic protection area ESA, the permeation reduction area MPA, and the crack reduction area CPA located on the third side of the display area DA.

On the third side of the display area DA, the first distribution circuit 710, the power connection portion PCA, the dam portion DMA, the data driver 700, the first pad portion PDA1, the electrostatic protection area ESA, the permeation reduction area MPA, and the crack reduction area CPA may be sequentially located in the second direction DR2. However, the present disclosure is not limited thereto, and the power connection portion PCA may overlap the first distribution circuit 710 or the data driver 700 in the third direction DR3, and the dam portion DMA may overlap the first distribution circuit 710 or the data driver 700 in the third direction DR3.

The first distribution circuit 710 may include a plurality of first distribution transistors DBTR1. Because each of the plurality of first distribution transistors DBTR1 may be formed substantially the same as the pixel transistors PTR described in conjunction with FIG. 7, a detailed description of the plurality of first distribution transistors DBTR1 will be omitted. In addition, because the first to eighth conductive layers ML1, ML2, ML3, ML4, ML5, ML6, ML7, and ML8 and the first to eighth vias VA1, VA2, VA3, VA4, VA5, VA6, VA7, and VA8 electrically connected to the plurality of first distribution transistors DBTR1 are also substantially the same as those described in conjunction with FIG. 7, a description thereof will be omitted.

The power connection portion PCA includes a first power connection area PCAA1 of the semiconductor substrate SSUB, a first power connection electrode PCE1, and a second power connection electrode PCE2.

The first driving voltage VSS may be applied to the first power connection area PCAA1 of the semiconductor substrate SSUB.

The first power connection electrode PCE1 may be located on the ninth insulating layer INS9. The first power connection electrode PCE1 may be connected to the first power connection area PCAA1 of the semiconductor substrate SSUB through the first to eighth conductive layers ML1, ML2, ML3, ML4, ML5, ML6, ML7, and ML8 and the first to eighth vias VA1, VA2, VA3, VA4, VA5, VA6, VA7, and VA8.

The first power connection electrode PCE1 may include first to fourth sub-power connection electrodes SPCE1, SPCE2, SPCE3, and SPCE4. The first to fourth sub-power connection electrodes SPCE1, SPCE2, SPCE3, and SPCE4 of the first power connection electrode PCE1 may be substantially the same as the first to fourth reflective electrodes RL1, RL2, RL3, and RL4 of the reflective electrode layer RL. That is, the first sub-power connection electrode layer SPCE1 may correspond to the first reflective electrode RL1, the second sub-power connection electrode layer SPCE2 may correspond to the second reflective electrode RL2, the third sub-power connection electrode layer SPCE3 may correspond to the third reflective electrode RL3, and the fourth sub-power connection electrode layer SPCE4 may correspond to the fourth reflective electrode RL4.

The second power connection electrode PCE2 may be located on the tenth insulating layer INS10. The second power connection electrode PCE2 may be connected to the first power connection electrode PCE1 through the tenth via VA10. The second power connection electrode PCE2 may include substantially the same material as the first electrode AND of the light-emitting element LE. The second power connection electrode PCE2 may be partitioned by the pixel-defining film PDL. The second electrode CAT of the light-emitting element LE may be connected to the second power connection electrode PCE2 that is exposed and not covered by the pixel-defining film PDL.

The dam portion DMA includes a first dam DM1 and a second dam DM2. The first dam DM1 and the second dam DM2 may be substantially the same as the trench TR. Each of the first dam DM1 and the second dam DM2 may penetrate the first pixel-defining film PDL1, the second pixel-defining film PDL2, and the third pixel-defining film PDL3. The tenth interlayer insulating layer INS10 may be partially recessed at each of the first dam DM1 and the second dam DM2.

In each of the first dam DM1 and the second dam DM2, the first encapsulation inorganic layer TFE1 may be located on the bottom surface, the encapsulation organic layer TFE2 may be located on the first encapsulation inorganic layer TFE1, and the second encapsulation inorganic layer TFE3 may be located on the encapsulation organic layer TFE2. The encapsulation organic layer TFE2 may be located to fill a part of each of the first dam DM1 and the second dam DM2. Alternatively, the encapsulation organic layer TFE2 may not be located on each of the first dam DM1 and the second dam DM2. That is, the first encapsulation inorganic layer TFE1 and the third encapsulation inorganic layer TFE3 may be located in each of the first dam DM1 and the second dam DM2.

The first dam DM1 and the second dam DM2 may reduce or prevent flow of the encapsulation organic layer TFE2 to the first pad portion PDA1 to avoid covering the first pads PD1. When the encapsulation organic layer TFE2 covers the first pads PD1, the first pads PD1 may not be electrically connected to the circuit board 300.

The data driver 700 may include a plurality of data transistors DTR. Because each of the plurality of data transistors DTR may be formed substantially the same as the pixel transistors PTR described in conjunction with FIG. 7, a detailed description of the plurality of data transistors DTR will be omitted. In addition, because the first to eighth conductive layers ML1, ML2, ML3, ML4, ML5, ML6, ML7, and ML8 and the first to eighth vias VA1, VA2, VA3, VA4, VA5, VA6, VA7, and VA8 electrically connected to the plurality of data transistors DTR are also substantially the same as those described in conjunction with FIG. 7, a description thereof will be omitted.

The electrostatic protection area ESA includes a second power connection area PCAA2 of the semiconductor substrate SSUB.

The first driving voltage VSS may be applied to the second power connection area PCAA2 of the semiconductor substrate SSUB. The second power connection area PCAA2 may be connected to the first to eighth conductive layers ML1, ML2, ML3, ML4, ML5, ML6, ML7, and ML8 and the first to eighth vias VA1, VA2, VA3, VA4, VA5, VA6, VA7, and VA8. Accordingly, the electrostatic protection area ESA may discharge static electricity applied from the outside to the first driving voltage VSS.

The permeation reduction area MPA includes a permeation reduction electrode MPE and a third power connection area PCAA3 of the semiconductor substrate SSUB.

The first driving voltage VSS may be applied to the third power connection area PCAA3 of the semiconductor substrate SSUB. Alternatively, the third power connection area PCAA3 of the semiconductor substrate SSUB may be electrically floating.

The permeation reduction electrode MPE may be substantially the same as the pad conductive layer PML illustrated in FIG. 9, the first pad conductive layer PML1 and the second pad conductive layer PML2 illustrated in FIG. 11, and the first pad conductive layer PML1, the second pad conductive layer PML2, and the third pad conductive layer PML3 illustrated in FIG. 13.

The permeation reduction electrode MPE may include a first sub-permeation reduction electrode SMPE1 and a second sub-permeation reduction electrode SMPE2. The first sub-permeation reduction electrode SMPE1 and the second sub-permeation reduction electrode SMPE2 of the permeation reduction electrode MPE may be substantially the same as the first sub-pad electrode PML1 and the second sub-pad electrode PML2 illustrated in FIGS. 7, 9, and 11. That is, the first sub-permeation reduction electrode SMPE1 may correspond to the first sub-pad electrode PML1, and the second sub-permeation reduction electrode SMPE2 may correspond to the second sub-pad electrode PML2.

The crack reduction area CPA includes a fourth power connection area PCAA4 of the semiconductor substrate SSUB.

The first driving voltage VSS may be applied to the fourth power connection area PCAA4 of the semiconductor substrate SSUB. Alternatively, the fourth power connection area PCAA4 of the semiconductor substrate SSUB may be electrically floating. The fourth power connection area PCAA4 may be connected to the first to eighth conductive layers ML1, ML2, ML3, ML4, ML5, ML6, ML7, and ML8 and the first to eighth vias VA1, VA2, VA3, VA4, VA5, VA6, VA7, and VA8.

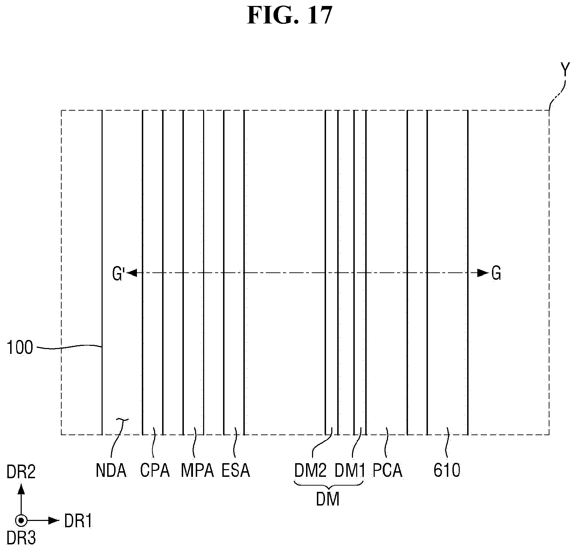

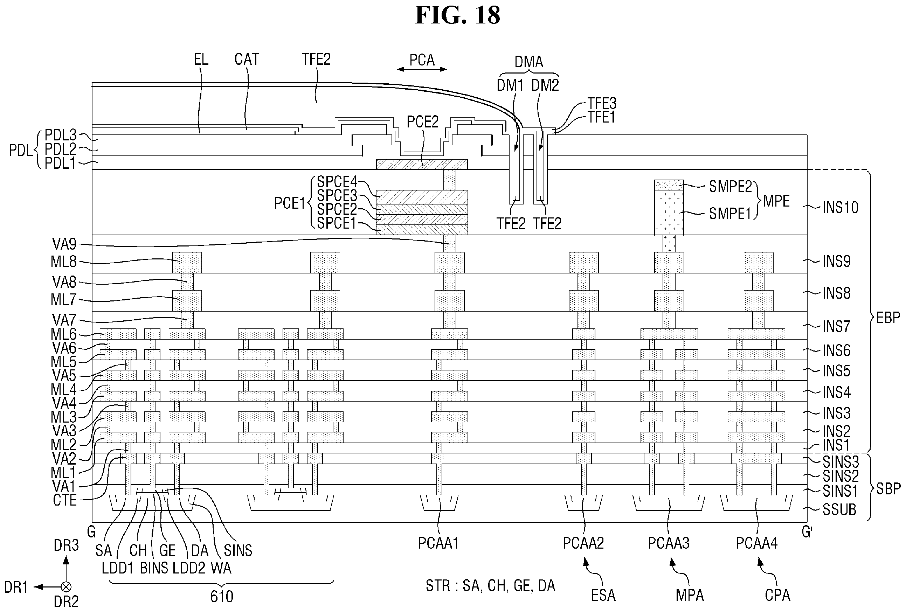

FIG. 17 is a layout diagram showing in detail an area Y of FIG. 4. FIG. 18 is a cross-sectional view illustrating a display panel taken along the line G-G' of FIG. 17.

Area Y in FIG. 4 may be an area located on the first side of the display area DA. FIGS. 17 and 18 illustrate the scan driver 610, the power connection portion PCA, the dam portion DMA, the electrostatic protection area ESA, the permeation reduction area MPA, and the crack reduction area CPA located on the first side of the display area DA.

On the first side of the display area DA, the scan driver 610, the power connection portion PCA, the dam portion DMA, the electrostatic protection area ESA, the permeation reduction area MPA, and the crack reduction area CPA may be sequentially located in the first direction DR1. However, the present disclosure is not limited thereto, and the power connection portion PCA may overlap the scan driver 610 in the third direction DR3, and the dam portion DMA may overlap the scan driver 610 in the third direction DR3.

The scan driver 610 may include a plurality of scan transistors STR. Because each of the plurality of scan transistors STR may be formed substantially the same as the pixel transistors PTR described in conjunction with FIG. 7, a detailed description of the plurality of scan transistors STR will be omitted. In addition, because the first to eighth conductive layers ML1, ML2, ML3, ML4, ML5, ML6, ML7, and ML8 and the first to eighth vias VA1, VA2, VA3, VA4, VA5, VA6, VA7, and VA8 electrically connected to the plurality of scan transistors STR are also substantially the same as those described in conjunction with FIG. 7, a description thereof will be omitted.

Because the power connection portion PCA, the dam portion DMA, the electrostatic protection area ESA, the permeation reduction area MPA, and the crack reduction area CPA are substantially the same as those described in conjunction with FIGS. 14 to 16, a description of the power connection portion PCA, the dam portion DMA, the electrostatic protection area ESA, the permeation reduction area MPA, and the crack reduction area CPA will be omitted in FIGS. 17 and 18.

In addition, because the area located on the second side of the display area DA is substantially the same as those illustrated in FIGS. 17 and 18, except that the scan driver 610 replaces the emission driver 620, a description thereof will be omitted.

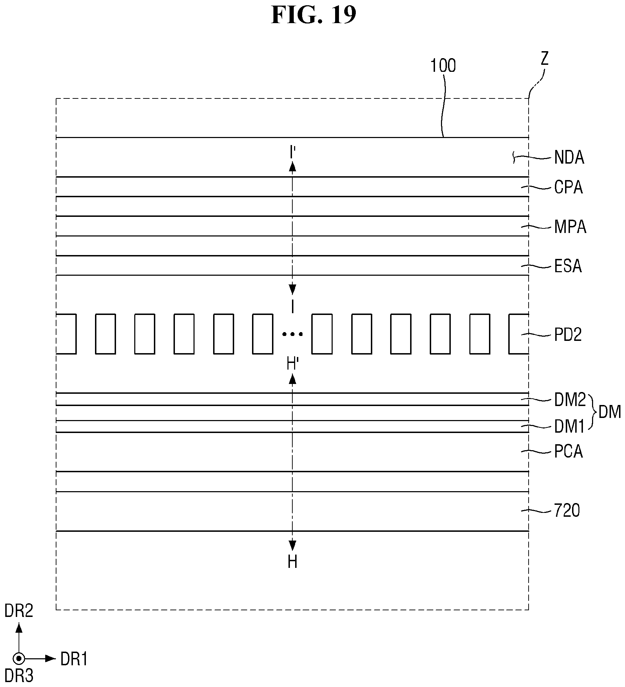

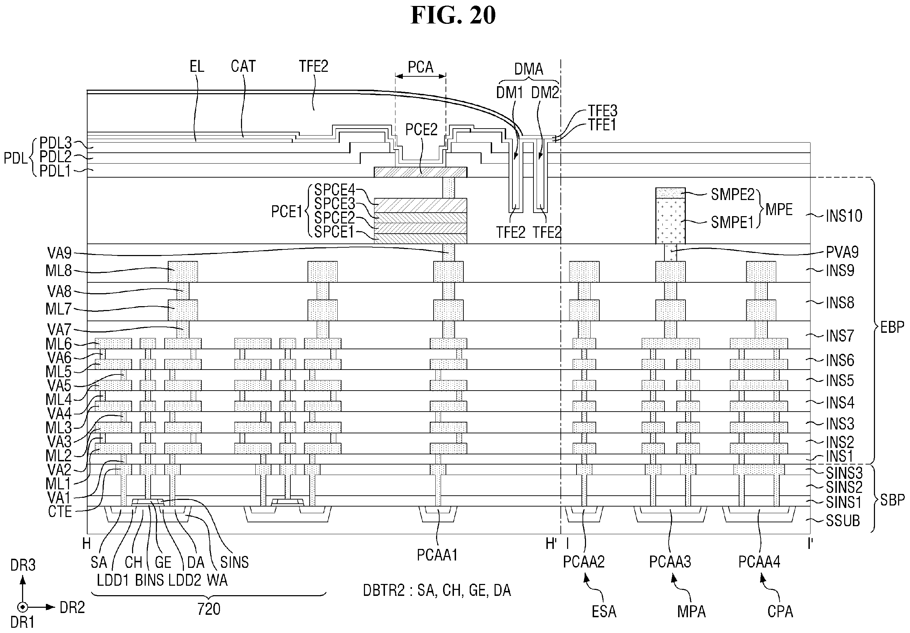

FIG. 19 is a layout diagram showing in detail an area Z of FIG. 4. FIG. 20 is a cross-sectional view illustrating a display panel taken along the lines H-H' and I-I' of FIG. 19.

Area Z in FIG. 4 may be an area located on the fourth side of the display area DA. FIGS. 19 and 20 illustrate the second distribution circuit 720, the power connection portion PCA, the dam portion DMA, the electrostatic protection area ESA, the permeation reduction area MPA, and the crack reduction area CPA located on the fourth side of the display area DA.

On the fourth side of the display area DA, the second distribution circuit 720, the power connection portion PCA, the dam portion DMA, the electrostatic protection area ESA, the permeation reduction area MPA, and the crack reduction area CPA may be sequentially located in the second direction DR2. However, the present disclosure is not limited thereto, and the power connection portion PCA may overlap the scan driver 610 in the third direction DR3, and the dam portion DMA may overlap the scan driver 610 in the third direction DR3.

The second distribution circuit 720 may include a plurality of second distribution transistors DBTR2. Because each of the plurality of second distribution transistors DBTR2 may be formed substantially the same as the pixel transistors PTR described in conjunction with FIG. 7, a detailed description of the plurality of second distribution transistors DBTR2 will be omitted. In addition, because the first to eighth conductive layers ML1, ML2, ML3, ML4, ML5, ML6, ML7, and ML8 and the first to eighth vias VA1, VA2, VA3, VA4, VA5, VA6, VA7, and VA8 electrically connected to the plurality of second distribution transistors DBTR2 are also substantially the same as those described in conjunction with FIG. 7, a description thereof will be omitted.

Because the power connection portion PCA, the dam portion DMA, the electrostatic protection area ESA, the permeation reduction area MPA, and the crack reduction area CPA are substantially the same as those described in conjunction with FIGS. 14 to 16, a description of the power connection portion PCA, the dam portion DMA, the electrostatic protection area ESA, the permeation reduction area MPA, and the crack reduction area CPA will be omitted in FIGS. 19 and 20.

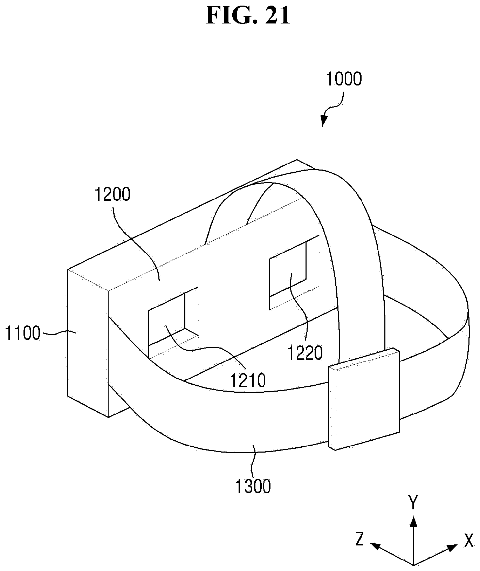

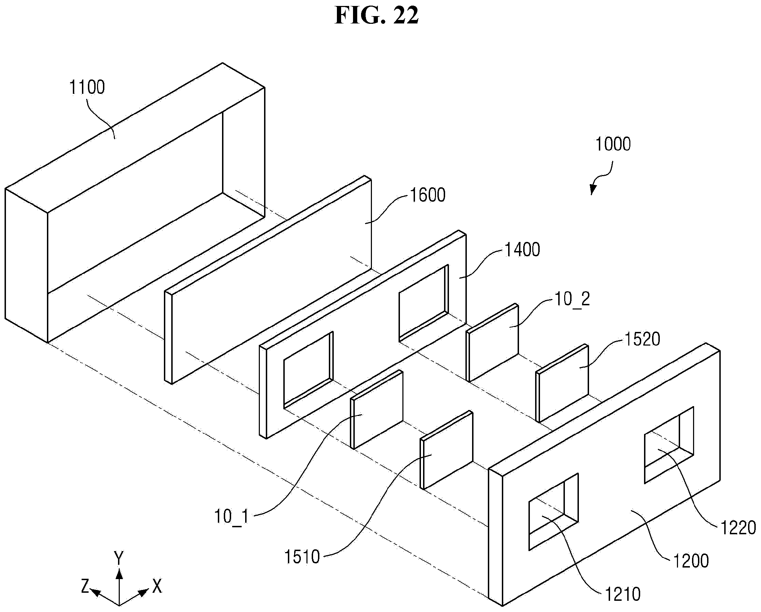

FIG. 21 is a perspective view illustrating a head mounted display device according to one or more embodiments. FIG. 22 is an exploded perspective view illustrating the head mounted display device of FIG. 21.

Referring to FIGS. 21 and 22, a head mounted display device 1000 according to one or more embodiments includes a first display device 10_1, a second display device 10_2, a display device housing 1100, a housing cover 1200, a first eyepiece 1210, a second eyepiece 1220, a head mounted band 1300, a middle frame 1400, a first optical member 1510, a second optical member 1520, and a control circuit board 1600.

The first display device 10_1 provides an image to the user's left eye, and the second display device 10_2 provides an image to the user's right eye. Because each of the first display device 10_1 and the second display device 10_2 is substantially the same as the display device 10 described in conjunction with FIGS. 1 and 2, a description of the first display device 10_1 and the second display device 10_2 will be omitted.

The first optical member 1510 may be located between the first display device 10_1 and the first eyepiece 1210. The second optical member 1520 may be located between the second display device 10_2 and the second eyepiece 1220. Each of the first optical member 1510 and the second optical member 1520 may include at least one convex lens.

The middle frame 1400 may be located between the first display device 10_1 and the control circuit board 1600 and between the second display device 10_2 and the control circuit board 1600. The middle frame 1400 serves to support and fix the first display device 10_1, the second display device 10_2, and the control circuit board 1600.

The control circuit board 1600 may be located between the middle frame 1400 and the display device housing 1100. The control circuit board 1600 may be connected to the first display device 10_1 and the second display device 10_2 through the connector. The control circuit board 1600 may convert an image source inputted from the outside into digital video data DATA, and transmit the digital video data DATA to the first display device 10_1 and the second display device 10_2 through the connector.

The control circuit board 1600 may transmit the digital video data DATA corresponding to a left-eye image intended or optimized for the user's left eye to the first display device 10_1, and may transmit the digital video data DATA corresponding to a right-eye image intended or optimized for the user's right eye to the second display device 10_2. Alternatively, the control circuit board 1600 may transmit the same digital video data DATA to the first display device 10_1 and the second display device 10_2.

The display device housing 1100 serves to accommodate the first display device 10_1, the second display device 10_2, the middle frame 1400, the first optical member 1510, the second optical member 1520, and the control circuit board 1600. The housing cover 1200 is located to cover one open surface of the display device housing 1100. The housing cover 1200 may include the first eyepiece 1210 at which the user's left eye is located and the second eyepiece 1220 at which the user's right eye is located. FIGS. 21 and 22 illustrate that the first eyepiece 1210 and the second eyepiece 1220 are located separately, but the present disclosure is not limited thereto. The first eyepiece 1210 and the second eyepiece 1220 may be combined into one.

The first eyepiece 1210 may be aligned with the first display device 10_1 and the first optical member 1510, and the second eyepiece 1220 may be aligned with the second display device 10_2 and the second optical member 1520. Therefore, the user may view, through the first eyepiece 1210, the image of the first display device 10_1 magnified as a virtual image by the first optical member 1510, and may view, through the second eyepiece 1220, the image of the second display device 10_2 magnified as a virtual image by the second optical member 1520.

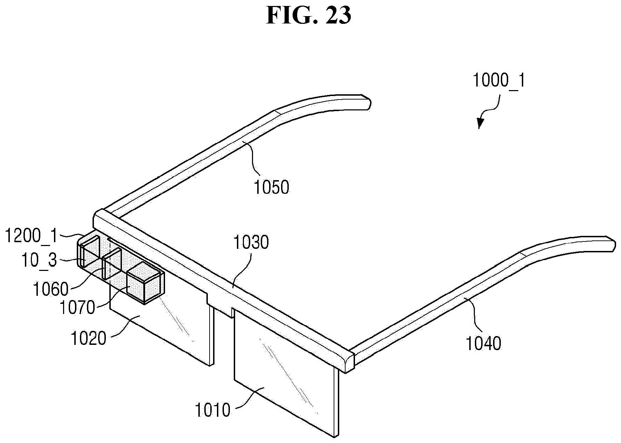

The head mounted band 1300 serves to secure the display device housing 1100 to the user's head such that the first eyepiece 1210 and the second eyepiece 1220 of the housing cover 1200 remain located on the user's left and right eyes, respectively. When the display device housing 1100 is implemented to be lightweight and compact, the head mounted display device 1000 may be provided with, as shown in FIG. 23, an eyeglass frame instead of the head mounted band 1300.

In addition, the head mounted display device 1000 may further include a battery for supplying power, an external memory slot for accommodating an external memory, and an external connection port and a wireless communication module for receiving an image source. The external connection port may be a universe serial bus (USB) terminal, a display port, or a high-definition multimedia interface (HDMI) terminal, and the wireless communication module may be a 5G communication module, a 4G communication module, a Wi-Fi module, or a Bluetooth module.

FIG. 23 is a perspective view illustrating a head mounted display device according to one or more embodiments.

Referring to FIG. 23, a head mounted display device 1000_1 according to one or more embodiments may be an eyeglasses-type display device in which a display device housing 1200_1 is implemented in a lightweight and compact manner. The head mounted display device 1000_1 according to one or more embodiments may include a display device 10_3, a left eye lens 1010, a right eye lens 1020, a support frame 1030, temples 1040 and 1050, an optical member 1060, an optical-path-changing member 1070, and the display device housing 1200_1.

The display device housing 1200_1 may include the display device 10_3, the optical member 1060, and the optical-path-changing member 1070. The image displayed on the display device 10_3 may be magnified by the optical member 1060, and may be provided to the user's right eye through the right eye lens 1020 after the optical path thereof is changed by the optical-path-changing member 1070. As a result, the user may view an augmented reality image, through the right eye, in which a virtual image displayed on the display device 10_3 and a real image seen through the right eye lens 1020 are combined.

FIG. 23 illustrates that the display device housing 1200_1 is located at the right end of the support frame 1030, but the present disclosure is not limited thereto. For example, the display device housing 1200_1 may be located at the left end of the support frame 1030, and in this case, the image of the display device 10_3 may be provided to the user's left eye. Alternatively, the display device housing 1200_1 may be located at both the left and right ends of the support frame 1030, and in this case, the user may view the image displayed on the display device 10_3 through both the left and right eyes.

It should be understood, however, that the aspects of embodiments of the present disclosure are not restricted to the one set forth herein. The above and other aspects of the present disclosure will become more apparent to one of ordinary skill in the art to which the present disclosure pertains by referencing the claims, with functional equivalents thereof to be included therein. Further Embodiments are set out in the following clauses:
Clause 1. A display device comprising:
   a semiconductor substrate comprising transistors;
   conductive layers above the semiconductor substrate;
   a reflective electrode layer above the conductive layers;
   an optical auxiliary layer above the reflective electrode layer;
   light-emitting elements above the optical auxiliary layer, and comprising a first electrode, a light-emitting stack, and a second electrode;
   a pixel-defining film above the first electrode to partition light-emitting areas of the light-emitting elements;
   a first pad conductive layer above the conductive layers; and
   a second pad conductive layer above the first pad conductive layer, a thickness of the first pad conductive layer and a thickness of the second pad conductive layer being greater than a thickness of the reflective electrode layer.
Clause 2. The display device of clause 1, wherein the first pad conductive layer and the second pad conductive layer comprise a first sub-pad and a second sub-pad partitioned by the optical auxiliary layer.
Clause 3. The display device of clause 2, wherein an area of the first sub-pad is larger than an area of the second sub-pad.
Clause 4. The display device of clause 2 or clause 3, wherein the first pad conductive layer and the second pad conductive layer further comprise a third sub-pad partitioned by the optical auxiliary layer.
Clause 5. The display device of clause 4, wherein an area of the first sub-pad is larger than an area of the second sub-pad, and wherein an area of the first sub-pad is larger than an area of the third sub-pad.
Clause 6. The display device of any preceding clause, further comprising a trench penetrating the pixel-defining film and a portion of the optical auxiliary layer.
Clause 7. The display device of clause 6, wherein the light-emitting stack comprises:
   a first stack layer for emitting light of a first color in the trench; and
   a second stack layer for emitting light of a second color in the trench and spaced apart from the first stack layer.
Clause 8. The display device of clause 7, wherein the light-emitting stack further comprises a first charge generation layer between the first stack layer and the second stack layer, and separated at the trench.
Clause 9. The display device of any one of clauses 6-8, wherein the pixel-defining film further comprises:
   a first pixel-defining film covering at least a part of the first electrode;
   a second pixel-defining film above the first pixel-defining film and exposing a part of a top surface of the first pixel-defining film; and
   a third pixel-defining film above the second pixel-defining film and exposing a part of a top surface of the second pixel-defining film.
Clause 10. The display device of clause 9, wherein the trench penetrates the first pixel-defining film, the second pixel-defining film, and the third pixel-defining film.
Clause 11. The display device of any preceding clause, wherein the reflective electrode layer comprises:
   a first reflective conductive layer;
   a second reflective conductive layer above the first reflective conductive layer; and
   a step layer between the first reflective conductive layer and the second reflective conductive layer.
Clause 12. The display device of any preceding clause, further comprising:
   a first power connection electrode above the conductive layers;
   a via penetrating the optical auxiliary layer covering the first power connection electrode to be connected to the first power connection electrode; and
   a second power connection electrode above the optical auxiliary layer, connected to the via, and connected to the second electrode.
Clause 13. The display device of clause 12, wherein the pixel-defining film is above at least a portion of the second power connection electrode.
Clause 14. The display device of clause 12 or clause 13, wherein the reflective electrode layer comprises a first reflective conductive layer, a second reflective conductive layer above the first reflective conductive layer, and a step layer between the first reflective conductive layer and the second reflective conductive layer, and
   wherein the first power connection electrode comprises a first sub-power connection electrode comprising a same material as the first reflective conductive layer, and a second sub-power connection electrode comprising a same material as the second reflective conductive layer.
Clause 15. The display device of any one of clauses 6 - 14, further comprising a dam penetrating the pixel-defining film, and a portion of the optical auxiliary layer.
Clause 16. The display device of clause 15, wherein a depth of the dam is substantially equal to a depth of the trench.
Clause 17. The display device of clause 15 or clause 16, further comprising an encapsulation layer above the light-emitting elements and the pixel-defining film, and comprising a first encapsulation inorganic layer in the dam, and an encapsulation organic layer.
Clause 18. The display device of clause 17, wherein the encapsulation organic layer is above the first encapsulation inorganic layer in the dam.
Clause 19. The display device of any preceding clause, wherein the first pad conductive layer and the second pad conductive layer further comprise a first sub-pad conductive layer, and a second sub-pad conductive layer having a thickness that is less than a thickness of the first sub-pad conductive layer,
   wherein the display device further comprising a permeation reduction electrode above the conductive layers, and
   wherein the permeation reduction electrode further comprises:
      a first sub-permeation reduction electrode comprising a same material as the first pad conductive layer; and
      a second sub-permeation reduction electrode comprising a same material as the second pad conductive layer.
Clause 20. A display device comprising:
   a display area comprising pixels;
   a power connection area outside the display area;
   a dam area outside the power connection area;
   a first distribution circuit at a first side of the display area in a first direction;
   a data driver outside the first distribution circuit in the first direction;
   a pad area outside the data driver in the first direction;
   an electrostatic protection area outside the pad area in the first direction;
   a permeation reduction area outside the electrostatic protection area in the first direction; and
   a crack reduction area outside the permeation reduction area in the first direction.
Clause 21. The display device of clause 20, wherein the power connection area surrounds the display area in plan view,
   wherein the dam area surrounds the power connection area in plan view,
   wherein the pad area is outside the dam area,
   wherein the electrostatic protection area surrounds the dam area in plan view,
   wherein the permeation reduction area surrounds the electrostatic protection area in plan view, and
   wherein the crack reduction area surrounds the permeation reduction area in plan view.
Clause 22. A head mounted display device comprising:
   a display device housing configured to accommodate at least one display device; and
   an optical member configured to magnify a display image of the at least one display device, or to change an optical path,
   wherein the at least one display device comprises:
      a semiconductor substrate comprising transistors;
      conductive layers above the semiconductor substrate;
      a reflective electrode layer above the conductive layers;
      an interlayer insulating layer above the reflective electrode layer;
      light-emitting elements above the interlayer insulating layer, and comprising a first electrode, a light-emitting stack, and a second electrode;
      a pixel-defining film above the first electrode to partition light-emitting areas where the light-emitting elements are respectively located;
      a first pad conductive layer above the conductive layers; and
      a second pad conductive layer above the first pad conductive layer, a thickness of the first pad conductive layer and a thickness of the second pad conductive layer being greater than a thickness of the reflective electrode layer.

## Claims

1. A display device comprising:
a semiconductor substrate comprising transistors;
conductive layers above the semiconductor substrate;
a reflective electrode layer above the conductive layers;
an optical auxiliary layer above the reflective electrode layer;
light-emitting elements above the optical auxiliary layer, and comprising a first electrode, a light-emitting stack, and a second electrode;
a pixel-defining film above the first electrode to partition light-emitting areas of the light-emitting elements;
a first pad conductive layer above the conductive layers; and
a second pad conductive layer above the first pad conductive layer, a thickness of the first pad conductive layer and a thickness of the second pad conductive layer being greater than a thickness of the reflective electrode layer.

2. The display device of claim 1, wherein the first pad conductive layer and the second pad conductive layer comprise a first sub-pad and a second sub-pad partitioned by the optical auxiliary layer wherein, optionally, an area of the first sub-pad is larger than an area of the second sub-pad.

3. The display device of claim 2, wherein the first pad conductive layer and the second pad conductive layer further comprise a third sub-pad partitioned by the optical auxiliary layer wherein, optionally, an area of the first sub-pad is larger than an area of the second sub-pad, and wherein an area of the first sub-pad is larger than an area of the third sub-pad.

4. The display device of any preceding claim, further comprising a trench penetrating the pixel-defining film and a portion of the optical auxiliary layer.

5. The display device of claim 4, wherein the light-emitting stack comprises:
a first stack layer in the trench, the first stack layer for emitting light of a first color; and
a second stack layer in the trench, the second stack layer for emitting light of a second color and spaced apart from the first stack layer;
wherein, optionally, the light-emitting stack further comprises a first charge generation layer between the first stack layer and the second stack layer, and separated at the trench.

6. The display device of claim 4 or claim 5, wherein the pixel-defining film further comprises:
a first pixel-defining film covering at least a part of the first electrode;
a second pixel-defining film above the first pixel-defining film and exposing a part of a top surface of the first pixel-defining film; and
a third pixel-defining film above the second pixel-defining film and exposing a part of a top surface of the second pixel-defining film;
wherein, optionally, the trench penetrates the first pixel-defining film, the second pixel-defining film, and the third pixel-defining film.

7. The display device of any preceding claim, wherein the reflective electrode layer comprises:
a first reflective conductive layer;
a second reflective conductive layer above the first reflective conductive layer; and
a step layer between the first reflective conductive layer and the second reflective conductive layer.

8. The display device of any preceding claim, further comprising:
a first power connection electrode above the conductive layers;
a via penetrating the optical auxiliary layer covering the first power connection electrode to be connected to the first power connection electrode; and
a second power connection electrode above the optical auxiliary layer, connected to the via, and connected to the second electrode;
wherein, optionally, the pixel-defining film is above at least a portion of the second power connection electrode.

9. The display device of claim 8, wherein the reflective electrode layer comprises a first reflective conductive layer, a second reflective conductive layer above the first reflective conductive layer, and a step layer between the first reflective conductive layer and the second reflective conductive layer, and
wherein the first power connection electrode comprises a first sub-power connection electrode comprising a same material as the first reflective conductive layer, and a second sub-power connection electrode comprising a same material as the second reflective conductive layer.

10. The display device of any one of claims 4-9, further comprising a dam penetrating the pixel-defining film, and a portion of the optical auxiliary layer.

11. The display device of claim 10, wherein a depth of the dam is substantially equal to a depth of the trench.

12. The display device of claim 10 or claim 11, further comprising an encapsulation layer above the light-emitting elements and the pixel-defining film, and comprising a first encapsulation inorganic layer in the dam, and an encapsulation organic layer, wherein, optionally, the encapsulation organic layer is above the first encapsulation inorganic layer in the dam.

13. The display device of any preceding claim, wherein the first pad conductive layer and the second pad conductive layer further comprise a first sub-pad conductive layer, and a second sub-pad conductive layer having a thickness that is less than a thickness of the first sub-pad conductive layer,
wherein the display device further comprising a permeation reduction electrode above the conductive layers, and
wherein the permeation reduction electrode further comprises:
a first sub-permeation reduction electrode comprising a same material as the first pad conductive layer; and
a second sub-permeation reduction electrode comprising a same material as the second pad conductive layer.

14. A display device according to any preceding claim, the display device comprising:
a display area comprising pixels, a pixel comprising the conductive layers, the reflective electrode layer, the optical auxiliary layer, the light-emitting elements, and the pixel-defining film;
a power connection area outside the display area;
a dam area outside the power connection area;
a first distribution circuit at a first side of the display area in a first direction;
a data driver outside the first distribution circuit in the first direction;
a pad area outside the data driver in the first direction, the pad area comprising the first pad conductive layer and the second pad conductive layer;
an electrostatic protection area outside the pad area in the first direction;
a permeation reduction area outside the electrostatic protection area in the first direction; and
a crack reduction area outside the permeation reduction area in the first direction
wherein, optionally, the power connection area surrounds the display area in plan view, the dam area surrounds the power connection area in plan view, the pad area is outside the dam area, the electrostatic protection area surrounds the dam area in plan view, the permeation reduction area surrounds the electrostatic protection area in plan view, and the crack reduction area surrounds the permeation reduction area in plan view.

15. A head mounted display device comprising:
a display device housing configured to accommodate at least one display device according to any one of claims 1 - 13; and
an optical member configured to magnify a display image of the at least one display device, or to change an optical path.
